# EUROPEAN PATENT SPECIFICATION

(11) **EP 3 305 519 B1**
(45) Date of publication and mention of the grant of the patent: **30.06.2021**
(21) Application number: 16802803.3
(22) Date of filing: 30.05.2016
(51) Int. Cl.: B32B 15/08, B29C 45/14, H01L 33/64, C08K 3/00, C08K 7/06, C08L 101/00

(54) **METAL RESIN COMPOSITE**
METALL-HARZ KOMPOSIT
COMPOSITE MÉTAL-RÉSINE

(30) Priority: 03.06.2015 JP 2015113372
(43) Date of publication of application: 11.04.2018
(73) Proprietor: Kaneka Corporation, Osaka-shi, Osaka 530-8288 (JP)
(72) Inventor: EZAKI, Toshiaki, Settsu-shi Osaka 566-0072 (JP)
(74) Representative: Vossius & Partner Patentanwälte Rechtsanwälte mbB
(86) International application number: PCT/JP2016/002615
(87) International publication number: WO 2016/194361

(56) References cited:
- EP-A1- 2 562 200
- WO-A1-2013/021848
- WO-A1-2015/002198
- WO-A1-2016/035680
- WO-A1-2016/063540
- WO-A1-2016/084397
- JP-A- 2008 173 967
- JP-A- 2011 061 157
- JP-A- 2013 052 671
- JP-A- 2013 052 671
- JP-A- 2014 001 847
- JP-A- 2014 024 959
- JP-A- 2014 091 826
- JP-A- 2016 002 654
- KR-A- 20130 018 555

## Description

### Technical Field

The present invention relates to a metal resin composite integrally molded by injection molding using a thermally conductive resin composition and a surface-treated metal. More specifically, the present invention relates to a metal resin composite having an excellent heat radiation property and moldability and lighter than metal.

### Background Art

Since electric and electronic devices have been reduced in size and highly integrated, heat generation of mounting components and a temperature increase of use environment become significant. Therefore, there is an increasing demand for the improvement of the heat radiation property of components. Currently, metals and ceramics having high thermal conductivity are used especially for heat radiating members of car members and high-power LEDs. However, in order to reduce weight, improve processability, and increase the degree of freedom of shapes, thermally conductive resin materials having high thermal conductivity and moldability have been required. However, there is a limit to an increase in the thermal conductivity of the thermally conductive resin material, and the heat radiation property of the thermally conductive resin material is inferior to that of metal in some cases. Therefore, technologies for improving the heat radiation property have been required.

Known as a method of improving the heat radiation property is a method of integrating resin with metal. PTL 1 describes a composite of a liquid crystal polyester resin composition having thermal conductivity and a metal. However, this composite is a composite of the metal which is not subjected to a surface treatment, and PTL 1 does not describe behaviors of joining of the metal and the resin.

Generally, resin causes thermal contraction at the time of molding. Thererfore, when compounding the metal not subjected to the surface treatment and the resin, a space is generated at a joint surface between the metal and the resin. Since this space becomes thermal resistance, and heat transfer becomes inadequate, there is room for improvement. Further, the thermally conductive resin composition has high thermal conductivity, and a solidifying speed of melted resin when the melted resin flows into a die is high. Therefore, there is a problem that the resin hardly flows into fine recesses generated on the surface of the metal by the surface treatment, and this causes inadequate joining strength. Therefore, when integrating the metal with the thermally conductive resin composition, a different material for reducing the thermal resistance needs to be used at an interface between the metal and the resin. However, there is a problem that such material is generally expensive, and this increases cost. Further, after the resin molded body is produced in advance, the metal member and the resin member need to be fixed to each other by adhesive, thermal welding, vibration welding, or the like.

### Citation List

### Patent Literature

PTL 1: Japanese Laid-Open Patent Application Publication No. 2014-024959
PTL2: Japanese Laid-Open Patent Application Publication No. 2013-052671 A relates to a specific method for producing an aluminum-resin composite, which comprises a roughening step of roughening the surface of an aluminum part with an etching agent and an adhesion step of adhering a resin composition to the roughened surface.
PTL3: Japanese Laid-Open Patent Application Publication No. 2014-091826 A concerns a particular molded article having a thickness of less than 3 mm, which is formed by molding a thermoplastic resin composition containing at least one or more kinds of plate-like or fibrous heat-conductive inorganic fillers.

### Summary of Invention

### Technical Problem

An object of the present invention is to provide a metal resin composite which is easily producible and in which a thermally conductive resin composition and a surface-treated metal are integrally molded by injection molding to be tightly joined to each other an interface between the resin and the metal.

### Solution to Problem

The present inventors have diligently studied to solve the above problems. As a result, the present inventors have found that the resin and the metal can be joined to each other at the interface in such a manner that: a thermally conductive resin composition and a surface-treated metal are integrally molded by injection molding, the thermally conductive resin composition containing a thermoplastic resin and an inorganic filler having a specific shape; and the thermally conductive resin composition flows into and is fixed to fine recesses on the surface of the metal. The present inventors have further found that the metal resin composite having an excellent heat radiation property can be produced without performing any of a step of providing a heat reducing material at the interface between the metal and the resin and a step of requiring fixing of the metal. Thus, the present invention was made.

To be specific, the present invention is shown by:
A metal resin composite according to claim 1 and a method of producing the metal resin composite according to claim 11.

### Advantageous Effects of Invention

According to the metal resin composite of the present invention, the thermally conductive resin composition and the surface-treated metal are integrally molded by injection molding to be joined to each other at the interface between the resin and the metal, the thermally conductive resin composition containing the thermoplastic resin and the inorganic filler having a specific shape. Thus, the metal resin composite of the present invention has an excellent heat radiation property and moldability, is light in weight, and is easily producible at low cost.

### Brief Description of Drawings

Fig. 1 is a perspective view of a typical example of a metal resin composite of the present invention.
Fig. 2 is a sectional view of the typical example of the metal resin composite of the present invention.
Fig. 3 is a perspective view of another typical example of the metal resin composite of the present invention.
Fig. 4 is a perspective view of yet another typical example of the metal resin composite of the present invention.
Fig. 5 is a sectional view of the yet another typical example of the metal resin composite of the present invention.
Fig. 6 is a top view of the yet another typical example of the metal resin composite of the present invention.
Fig. 7 is a top view and side view of the metal resin composite produced when measuring joining strength.

### Description of Embodiments

A surface treatment in the present invention is a treatment of forming fine recesses on a surface of a metal. Examples of the surface treatment include: chemical etching treatments and fine etching treatments using acidic aqueous solutions, basic aqueous solutions, special chemical liquids, and the like; physical polishing treatments such as mechanical polishing and laser irradiation; and anodic oxidation treatments. Further, a plurality of these surface treatment technologies may be used in combination.

According to a principle of joining between a thermally conductive resin composition and a metal in the present invention, the thermally conductive resin composition and the metal are joined to each other in such a manner that the resin in a melted state injected in a below-described injection molding step flows into and is fixed to the recesses formed on the surface of the metal by the surface treatment. Heat transfer improves as a joining area between the metal member and the resin member increases. Thus, a heat radiation property improves. The heat radiation property further improves as emissivity of the metal member decreases. Furthermore, joining strength between the resin member and the metal member increases by an anchor effect as the shapes of the recesses become finer and more complex. Due to the above reasons, the finer the recesses formed on the treated surface of the metal member are, the better.

A number average inner diameter of the recesses formed on the surface of the metal by the surface treatment in the present invention is 10 µm or less, preferably 5 µm or less, and more preferably 3 µm or less by measurement of electron microscopic observation. A lower limit of the number average inner diameter of the recesses is not especially limited but is preferably 1 nm or more and more preferably 10 nm or more. By setting the number average inner diameter of the recesses within the above range, the recesses are adequately formed on a joining scheduled surface of the metal member, and the thermally conductive resin composition in a melted state injected in the below-described injection molding step gets into the recesses, so that the joining strength between the resin member and the metal member increases. If the number average inner diameter of the recesses is more than 10 µm, the anchor effect cannot be obtained, and adequate joining may not be realized. If the number average inner diameter of the recesses is less than 1 nm, the melted thermally conductive resin composition cannot flow into the recesses, and joining may not be realized.

The number average inner diameter of the recesses can be easily adjusted within a desired range by adjusting metal surface treatment conditions (such as a treatment time, a type of a treatment liquid, concentration of the treatment liquid, and a treatment temperature). Especially, since the amount of hydroxyl groups on the surface of the metal can be increased depending on the type of the treatment liquid, the improvement of the joining strength between the resin member and the metal member by chemical bond can also be expected. The following will describe preferable surface treatment methods among the above-described surface treatment methods in the present invention.

### Surface Treatment Method 1

A surface treatment method 1 is a chemical etching treatment and/or a fine etching treatment. The chemical etching treatment herein is a treatment method of forming the recesses on the surface of the metal such that: an interval between adjacent recesses is 1 to 100 µm; and each of height differences of the recesses is less than about half the interval. The fine etching treatment is a treatment of forming the fine recesses on the surface of the metal such that an interval between adjacent recesses is 1 to 500 nm. Depending on the type of the metal used, the execution of the chemical etching treatment may include the fine etching treatment. Further, the chemical etching treatment may include removal of a film on the surface of the metal. The effects of the present invention can be obtained even by each of these treatments. However, performing both of these treatments is preferable. Especially, performing the fine etching treatment after the chemical etching treatment is performed is preferable. By performing both of these treatments, nano-order fine recesses can be formed on micron-order recesses formed on the surface of the metal. Thus, the melted resin flows into the formed recesses, and the resin and the metal can be strongly joined by the anchor effect.

The chemical etching treatment is not especially limited as long as it is a technology capable of forming micron-order recesses on the joining scheduled surface, and a conventionally known method may be used. Examples of the treatment liquid include aqueous solutions containing hydrogen peroxide, sulfuric acid, nitric acid, hydrochloric acid, benzotriazole, sodium hydroxide, or sodium chloride. The surface treatment by chemical etching is performed by immersing the metal member in the treatment liquid. Among these chemical etching treatments, a treatment of immersing the metal member in the acidic aqueous solution and/or the basic aqueous solution is preferable.

The acidic aqueous solution used in the chemical etching treatment is not especially limited. However, an aqueous solution containing halogen hydrogen acid, hydrofluoric acid derivative, or nitric acid at a concentration of 0.5 to 5.0% is preferable, and an aqueous solution containing hydrochloric acid, nitric acid, or ammonium bifluoride and controlled to have a temperature of 35 to 40°C is more preferable. The basic aqueous solution is not especially limited, but an alkali metal hydroxide aqueous solution at a concentration of 0.5 to 3.0% is preferable, and a caustic soda aqueous solution controlled to have a temperature of 35 to 40°C is especially preferable. The type of the treatment liquid used is determined based on the composition of respective metals contained in the metal. Therefore, an optimal aqueous solution is selected based on actual experiments. Reproducibility may improve by using ultrasound during immersing.

The fine etching treatment is not especially limited, but it is preferable to immerse the metal member in an aqueous solution of a water-soluble amine compound such as ammonia or hydrazine. When the treatment using the above aqueous solution is performed, ultrafine recesses are formed on the surface of the metal, and the amine compound is adsorbed to the surface of the metal. Since the amine compound chemically adsorbed to the surface of the metal and the melted resin react with each other to generate heat, solidification of the melted resin is delayed, and the melted resin easily flows into the recesses. This principle is called a "NMT (nano molding technology)" theory.

The amine compound used in the fine etching treatment is an amine compound in a broad sense, and specific examples thereof include ammonia, hydrazine, methylamine, dimethylamine, trimethylamine, ethylamine, diethylamine, triethylamine, ethylenediamine, ethanolamine, allylamine, ethanolamine, diethanolamine, triethanolamine, aniline, and other amines.

Among these, hydrazine is especially preferable. This is because hydrazine has low odor, is effective at a low concentration, is low in cost, and the like. The immersion of the metal member is performed at 40 to 80°C, especially preferably 50 to 70°C. The concentration of the aqueous solution varies depending on the compound used. In the case of hydrazine, an aqueous solution containing hydrazine monohydrate (N₂H₄·H₂O) at a concentration of 2 to 10% is preferable, and an aqueous solution containing hydrazine monohydrate (N₂H₄·H₂O) at a concentration of 3 to 5% is especially preferable. An immersion time is preferably 30 to 90 seconds. After the immersion, the metal member is washed with water and dried by hot air at 40 to 90°C.

It is preferable that the surface-treated metal member be kept under dry air and prevented from being exposed to moisture. Further, it is preferable that the surface-treated metal member be used within one week after the treatment.

The number average inner diameter of the recesses formed on the surface of the metal by the surface treatment method 1 is preferably 1 to 200 nm, more preferably 5 to 100 nm, and further preferably 10 to 80 nm.

As examples of the chemical etching treatment and the fine etching treatment, the foregoing has described the treatment methods based on the NMT theory. However, the present invention is not limited to these treatment methods. For example, a method may be used, in which after fine recesses having predetermined shapes are formed on the surface of the metal, the surface of the metal is covered with a ceramic type hard phase thin layer. It is preferable to use, for example, a brass member covered with a thin layer mainly containing cupric oxide or zinc phosphate based compound.

### Surface Treatment Method 2

A surface treatment method 2 is a method of forming fine recesses on the surface of the metal by subjecting the surface of the metal to laser irradiation. The type of the laser beam is not especially limited, but continuous irradiation of continuous wave laser is preferable since recesses having finer and more complex shapes are easily formed. With this, the recesses are formed in a thickness direction of the member made of the metal, and a structure in which such recesses are covered with finer recesses can be formed.

As described in International Publication No. 2015/008771, an optimal irradiation condition of the continuous wave laser is as below.

An irradiation speed of the continuous wave laser is preferably 2,000 to 20,000 mm/sec, more preferably 5,000 to 20,000 mm/sec, and further preferably 8,000 to 20,000 mm/sec. When the irradiation speed of the continuous wave laser is within the above range, a processing speed can be increased, and the joining strength can be kept at a high level.

In this step, it is preferable to perform the continuous irradiation of the laser beam such that a processing time when the following requirements (i) and (ii) are satisfied is in a range of 0.01 to 30 seconds.
(i) The irradiation speed of the laser beam is 5,000 to 20,000 mm/sec.
(ii) The area of the joint surface of the metal resin composite is 100 mm².

In a case where the processing time when the requirements (i) and (ii) are satisfied is within the above range, the recesses can be formed on the entire joining scheduled surface.

The continuous irradiation of the laser beam can be performed under, for example, the following conditions. An output of the laser beam is preferably 4 to 4,000 W, more preferably 50 to 1,000 W, and further preferably 100 to 500 W. A wavelength of the laser beam is preferably 300 to 1,200 nm and more preferably 500 to 1,200 nm. A beam diameter (spot diameter) of the laser beam is preferably 5 to 200 µm, more preferably 5 to 100 µm, and further preferably 5 to 50 µm. A focal position of the laser beam is preferably -10 to +10 mm and more preferably -6 to +6 mm.

As the continuous wave laser, a known laser may be used. Examples of the continuous wave laser include a YV04 laser, a fiber laser (preferably a single mode fiber laser), an excimer laser, a carbon dioxide laser, an ultraviolet laser, a YAG laser, a semiconductor laser, a glass laser, a ruby laser, a He-Ne laser, a nitrogen laser, a chelate laser, and a dye laser. Among these, the fiber laser is preferable, and the single mode fiber laser is especially preferable, since an energy density can be increased.

The surface-treated metal of the present invention may also be subjected to a treatment of fixing chemical substances to the surface of the metal, a treatment of forming an oxide film by anodic oxidation, or the like according to need.

The chemical substance fixed to the surface of the metal is not especially limited as long as it is a known compound that can react with and be fixed to metal. Examples of such chemical substance include: various silane coupling agents such as epoxysilane and aminosilane; and triazine dithiol derivatives. Specific examples of the triazine dithiol derivative include:
1,3,5-triazine-2,4,6-trithiole; 1,3,5-triazine-2,4,6-trithiole·monosodium;
1,3,5-triazine-2,4,6-trithiole·triethanolamine; 6-anilino-1,3,5-triazine-2,4-dithiol;
6-anilino-1,3,5-triazine-2,4-dithiol·monosodium; 6-dibutylamino-1,3,5-triazine-2,4-dithiol;
6-dibutylamino-1,3,5-triazine-2,4-dithiol·monosodium; 6-diallylamino-1,3,5-triazine-2,4-dithiol;
6-diallylamino-1,3,5-triazine-2,4-dithiol·monosodium; 1,3,5-triazine-2,4,6-trithiole·ditetrabutyl
ammonium salt; 6-dibutylamino-1,3,5-triazine-2,4-dithiol·tetrabutyl ammonium salt;
6-dithioctylamino-1,3,5-triazine-2,4-dithiol;
6-dithioctylamino-1,3,5-triazine-2,4-dithiol·monosodium;
6-dilaurylamino-1,3,5-triazine-2,4-dithiol;
6-dilaurylamino-1,3,5-triazine-2,4-dithiol·monosodium;
6-stearylamino-1,3,5-triazine-2,4-dithiol;
6-stearylamino-1,3,5-triazine-2,4-dithiol-monopotassium;
6-oleylamino-1,3,5-triazine-2,4-dithiol; and
6-oleylamino-1,3,5-triazine-2,4-dithiol·monopotassium.

One example of the method of fixing the above chemical substance to the surface of the metal is a method of: using an aqueous solution of the above chemical substance or a solution of the above chemical substance in an organic solvent such as methyl alcohol, isopropyl alcohol, ethyl alcohol, acetone, toluene, ethylcellosolve, dimethyl formaldehyde, tetrahydrofuran, methyl ethyl ketone, benzene, or acetic acid ethyl ether; using the metal member as an anode; using a platinum plate, a titanium plate, a carbon plate, or the like as a cathode; and applying a current of 0.1 to 10 A/dm² at a voltage of 20 V or less and a temperature of 0 to 80°C for 0.1 second to 10 minutes.

An anodic oxidation film denotes an oxide film formed on the surface of the metal when electricity is supplied in an electrolyte solution using the metal member as the anode.
One example of the electrolyte is the above-described water-soluble amine compound.

The type of the metal subjected to the surface treatment is not especially limited. Examples of the metal include: aluminum and alloy containing aluminum (aluminum alloy); copper and alloy containing copper (brass, bronze, aluminum brass, etc.); nickel; chromium; titanium; iron; cobalt; tin; zinc; palladium; silver; stainless steel; magnesium and alloy containing magnesium (magnesium alloy); and manganese. Among these metals, aluminum, alloy containing aluminum, copper, alloy containing copper, magnesium, and alloy containing magnesium are preferable, and aluminum and alloy containing aluminum are more preferable, since each of these metals has the thermal conductivity of 40 W/(m·K) or more and can be easily obtained.

The types of aluminum and alloy containing aluminum are not especially limited. Examples thereof include: A1,000-7,000 series of Japanese Industrial Standards; and ADC12 that is aluminum alloy for casting. At least one or more of these are used in accordance with applications required. Among these, A1,000 series, A5052, and ADC12 are preferable from the viewpoint of thermal conductivity and frequency of use.

A thickness of the metal member is not especially limited but is preferably 5 mm or less, more preferably 3 mm or less, further preferably 2 mm, and especially preferably 1 mm or less. The thinner the metal member is, the better. This is because weight reduction can be realized.

A shape of the metal member is not especially limited. Examples of the shape of the metal member include a flat plate shape, a curved plate shape, a rod shape, a tubular shape, a block shape, and the metal member may be a structure having a combination of these shapes. Further, the metal member may have a through hole, a bent portion, and/or the like.

If rust or the like exists on the surface of the metal since the metal is left for a long period of time, it is preferable to remove the rust or the like by polishing. Further, in the case of the metal member shaped by casting using the aluminum alloy for casting such as ADC12, typically, a surface layer composition of the metal member is different from an internal composition thereof, and the surface layer composition is nonuniform. Therefore, in the case of this material, it is preferable to remove the surface layer, whose composition is nonuniform, in advance by polishing or the like.

Generally, processing oil or finger oil is attached to the surface of the metal. Therefore, it is preferable to degrease the metal and wash the metal with water. If the amount of oil attached is large, a two-stage degreasing step may be performed. A method of performing degreasing twice using a commercially available degreasing agent aqueous solution while sandwiching water washing may be used. Or, a method of washing the metal with an organic solvent such as trichlene to remove most of oil and then degreasing the metal with a degreasing agent aqueous solution may be used.

Contacting/joining by the injection molding in the present invention is a molding method of: attaching a die to an outlet of an injection molding device; placing the surface-treated metal member in the die; injecting the thermally conductive resin composition, melted and plasticized in the injection molding device, into the die; cooling and solidifying the thermally conductive resin composition; and taking out the resulting product. The injection molding device and the die used here are not especially limited. To more efficiently achieve the effects of the present invention, it is preferable to use a heat and cool injection molding method of: setting the temperature of the die to not less than a resin softening point and a crystallization temperature for the purpose of causing the melted resin to flow into the fine recesses on the surface of the metal; performing molding; instantly reducing the temperature of the die to a solidifying temperature; and taking out a molded body. It is also preferable to use a hot runner gate, which can be set to a resin melting point or more, at a runner portion of the die.

The injection molding of the present invention can be performed under the substantially same conditions as conventional injection molding. However, to more efficiently join both members to each other, it is preferable that high-temperature high-pressure melted resin contact the surface of the metal member in a state where gases are adequately released, and obstacles are removed. Therefore, it is preferable that degassing be adequately performed when constituting the die.

The thermally conductive resin composition of the present invention is a resin composition containing a thermoplastic resin (A) and an inorganic filler (B).

### Thermoplastic Resin (A)

Examples of the thermoplastic resin (A) of the present invention include: aromatic vinyl based resin such as polystyrene; vinyl cyanide based resin such as polyacrylonitrile; chlorine based resin such as polyvinyl chloride; polymethacrylic ester based resin such as polymethyl methacrylate; polyacrylic ester based resin; polyolefin based resin such as polyethylene, polypropylene, cyclic polyolefin resin; polyvinyl ester based resin such as polyvinyl acetate; polyvinyl alcohol based resin; derivative resin of polyvinyl alcohol based resin; polymethacrylic acid based resin; polyacrylic acid based resin; metal salt based resin of polymethacrylic acid based resin; metal salt based resin of polyacrylic acid based resin; poly-conjugated diene based resin; polymer produced by polymerizing maleic acid, fumaric acid, and derivatives of maleic acid and fumaric acid; polymer produced by polymerizing maleimide based compound; amorphous polyester based resin such as amorphous semi-aromatic polyester, amorphous wholly aromatic polyester, and polycarbonate; crystalline polyester based resin such as crystalline semi-aromatic polyester and crystalline wholly aromatic polyester; polyamide based resin such as aliphatic polyamide, aliphatic-aromatic polyamide, and wholly aromatic polyamide; polycarbonate based resin; polyurethane based resin; polysulfone based resin; polyalkylene oxide based resin; cellulose based resin; polyphenylene ether based resin; polyphenylene sulfide based resin; polyketone based resin; polyimide based resin; polyamidimide based resin; polyether imide based resin; polyether ketone based resin; polyether ether ketone based resin; polyvinyl ether based resin; phenoxy based resin; fluorine based resin; silicone based resin; liquid crystal polymer; random copolymer, block copolymer, and graft copolymer of the above polymers. These thermoplastic resins may be used alone or in combination of two or more. When using a combination of two or more resins, a compatibilizer or the like may be added according to need. The thermoplastic resin (A) used may be suitably determined depending on the purpose.

Among these thermoplastic resins, preferable examples of the thermoplastic resin include: amorphous or crystalline polyester based resin; polycarbonate based resin; liquid crystal polyester based resin; polyamide based resin; polyphenylene sulfide based resin; and polyolefin based resin.

Among these thermoplastic resins, a thermoplastic resin which is partially or wholly crystalline or liquid crystalline is preferable. This is because the thermal conductivity of the obtained resin composition tends to be high. The crystalline or liquid crystal thermoplastic resin may be wholly crystalline or may be partially crystalline or liquid crystalline, such as a case where only specific blocks in molecules of block or graft copolymer resin are crystalline or liquid crystalline. The degree of crystallinity of the resin is not especially limited. As the thermoplastic resin, a polymer alloy of amorphous resin and crystalline or liquid crystal resin may be used. The degree of crystallinity of the resin is not especially limited.

Among the thermoplastic resins each of which is partially or wholly crystalline or liquid crystalline, there is a resin which can be crystallized but may show an amorphous property when the resin is used alone or molded under a specific molding condition. Even in the case of using such resin, the resin may be able to be partially or wholly crystallized by devising a molding method, such as performing a stretch treatment or a post crystallization treatment.

Preferable examples of the crystalline or liquid crystal thermoplastic resin include: crystalline polyester based resin; crystalline polyamide based resin; polyphenylene sulfide based resin; liquid crystal polymer; crystalline polyolefin based resin; and polyolefin based block copolymer. However, the preferable examples of the crystalline or liquid crystal thermoplastic resin are not limited to these, and various crystalline resins and liquid crystal resins may be used.

Specific examples of the crystalline polyester resin include: polyethylene terephthalate; polypropylene terephthalate; polybutylene terephthalate;
polyethylene-2,6-naphthalate; polybutylene naphthalate; poly 1,4-cyclohexylene dimethylene terephthalate; polyethylene-1,2-bis(phenoxy)ethane-4,4'-dicarboxylate; and crystalline copolyesters, such as polyethylene isophthalate/terephthalate, polybutylene terephthalate/isophthalate, polybutylene terephthalate/decane dicarboxylate, polycyclohexane dimethylene terephthalate/isophthalate, and polyester/polyether. Among these crystalline polyesters, polyethylene terephthalate, polypropylene terephthalate, polybutylene terephthalate, polyethylene-2,6-naphthalate, polybutylene naphthalate, poly 1,4-cyclohexylene dimethylene terephthalate, polyester/polyether, and the like are preferable from the viewpoint of moldability, a mechanical property, and the like.

Specific examples of the crystalline polyamide based resin include: ring-opening polymer of cyclic lactam; polycondensate of aminocarboxylic acid; and polycondensate of dicarboxylic acid and diamine. More specific examples of the crystalline polyamide based resin include: aliphatic polyamide such as nylon 6, nylon 4·6, nylon 6·6, nylon 6·10, nylon 6·12, nylon 11, and nylon 12; aliphatic-aromatic polyamide such as poly(metaxyleneadipamide), poly(hexamethylene terephthalamide), poly(hexamethylene isophthalamide), polynonane methylene terephthalamide, poly(tetramethylene isophthalamide), and poly(methyl pentamethylene terephthalamide); and copolymers of these. Examples of the copolymers include: nylon 6/poly(hexamethylene terephthalamide); nylon 66/poly(hexamethylene terephthalamide); nylon 6/nylon 6·6/poly(hexamethylene isophthalamide); poly(hexamethylene isophthalamide)/poly(hexamethylene terephthalamide); nylon 6/poly(hexamethylene isophthalamide)/poly(hexamethylene terephthalamide); nylon 12/poly(hexamethylene terephthalamide); and poly(methyl pentamethylene terephthalamide)/poly(hexamethylene terephthalamide). It should be noted that the type of the copolymerization may be any of random copolymerization and block copolymerization. From the viewpoint of the moldability, random copolymer is preferable.

Among the crystalline polyamide based resins, from the viewpoint of the moldability, the mechanical property, and the like, preferable examples include: nylon 6; nylon 6·6; nylon 4·6; nylon 12; polynonane methylene terephthalamide; nylon 6/poly(hexamethylene terephthalamide); nylon 66/poly(hexamethylene terephthalamide); nylon 6/nylon 6·6/poly(hexamethylene isophthalamide); poly(hexamethylene isophthalamide)/poly(hexamethylene terephthalamide); nylon 6/poly(hexamethylene isophthalamide)/poly(hexamethylene terephthalamide); nylon 12/poly(hexamethylene terephthalamide); nylon 6/nylon 6·6/poly(hexamethylene isophthalamide); and poly(methyl pentamethylene terephthalamide)/poly(hexamethylene terephthalamide). Among these polyamide based resins, nylon 6, nylon 6,6, nylon 4,6, and nylon 12 are more preferable.

The liquid crystal polymer is a resin which may form an anisotropic molten phase, and the liquid crystal polymer having ester bond is preferable. Specific examples of the liquid crystal polymer include: liquid crystalline polyester having a structural unit selected from an aromatic oxycarbonyl unit, an aromatic dioxy unit, an aromatic and/or aliphatic dicarbonyl unit, an alkylenedioxy unit, etc. and forming an anisotropic molten phase; and liquid crystalline polyester amide having the above structural unit and another structural unit selected from an aromatic iminocarbonyl unit, an aromatic diimino unit, an aromatic imonoxy unit, etc. and forming an anisotropic molten phase.

Specific examples of the liquid crystalline polyester include: liquid crystalline polyester having a structural unit generated from p-hydroxy benzoic acid and 6-hydroxy-2-naphthoic acid; liquid crystalline polyester having a structural unit generated from p-hydroxy benzoic acid, a structural unit generated from 6-hydroxy-2-naphthoic acid, and a structural unit generated from aromatic dihydroxy compound and/or aliphatic dicarboxylic acid; liquid crystalline polyester having a structural unit generated from p-hydroxy benzoic acid, a structural unit generated from 4,4'-dihydroxy biphenyl, a structural unit generated from aromatic dicarboxylic acid (such as terephthalic acid and isophthalic acid) and/or aliphatic dicarboxylic acid (such as adipic acid and sebacic acid); liquid crystalline polyester having a structural unit generated from p-hydroxy benzoic acid, a structural unit generated from ethylene glycol, and a structural unit generated from terephthalic acid; liquid crystalline polyester having a structural unit generated from p-hydroxy benzoic acid, a structural unit generated from ethylene glycol, and a structural unit generated from terephthalic acid and isophthalic acid; liquid crystalline polyester having a structural unit generated from p-hydroxy benzoic acid, a structural unit generated from ethylene glycol, a structural unit generated from 4,4'-dihydroxy biphenyl, and a structural unit generated from terephthalic acid and/or aliphatic dicarvone (such as adipic acid and sebacic acid); and liquid crystalline polyester having a structural unit generated from p-hydroxy benzoic acid, a structural unit generated from ethylene glycol, a structural unit generated from aromatic dihydroxy compound, and a structural unit generated from aromatic dicarboxylic acid such as terephthalic acid, isophthalic acid, and 2,6-naphthalene dicarboxylic acid. Further, one example of the liquid crystalline polyester amide is polyester amide forming an anisotropic molten phase and having: a structural unit selected from an aromatic oxycarbonyl unit, an aromatic dioxy unit, an aromatic and/or aliphatic dicarbonyl unit, and an alkylenedioxy unit; and a p-imino phenoxy unit generated from p-amino phenol.

Specific examples of the crystalline polyolefin based resin include polyethylene, polypropylene, polybutene, polyisobutylene, and copolymers of these resins and various olefine based compounds. A block or graft copolymer of crystalline resin and amorphous resin may be used as the crystalline polyolefin based resin. Among these resins, specific examples of the block copolymer include SEPS resin, SIS resin, SEBS resin, and SIBS resin. Further, specific examples of the graft copolymer include resins described in Japanese Laid-Open Patent Application Publication No. 2003-147032.

The above-described polyester/polyether (hereinafter referred to as "polyester-polyether copolymer") is a block or random copolymer made of a polyester unit and a polyether unit. Examples of the polyether unit include: a polyalkylene oxide unit, such as a polyethylene oxide unit and a polybutylene oxide unit; and a modified polyether unit. It is preferable that the modified polyether unit be represented by general formula (1) below. From the viewpoint of moldability and heat resistance, the polyester-polyether copolymer is preferably a polymer made of 95 to 45 wt.% of an aromatic polyester unit and 5 to 55 wt.% of the modified polyether unit, more preferably a polymer made of 80 to 50 wt.% of the aromatic polyester unit and 20 to 50 wt.% of the modified polyether unit, and further preferably a polymer made of 80 to 60 wt.% of the aromatic polyester unit and 20 to 40 wt.% of the modified polyether unit.

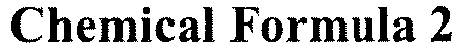

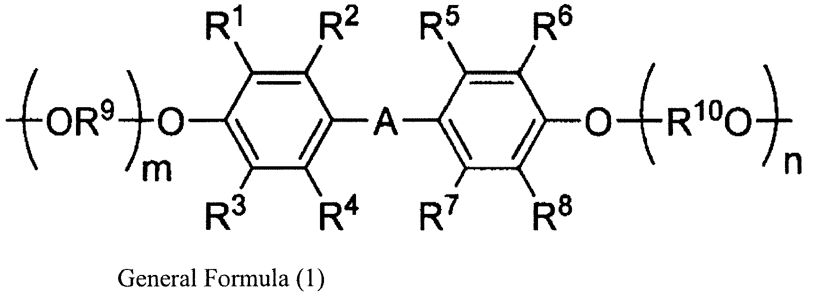

A method of producing the polyester-polyether copolymer uses a catalyst containing an antimony compound or a catalyst containing a germanium compound in some cases, and examples of such method include (1) a direct esterification method using three elements that are an aromatic dicarboxylic acid, a diol, and a modified polyether, (2) a transesterification method using three elements that are aromatic dialkyl dicarboxylate, diol, and modified polyether and/or modified polyether ester, (3) a method of adding modified polyether during or after transesterification of aromatic dialkyl dicarboxylate and diol to perform polycondensation, and (4) a method of mixing high-molecular weight aromatic polyester with modified polyether and melting the mixture to perform transesterification under reduced pressure. However, the method of producing the polyester-polyether copolymer is not limited to these. The producing method (4) is preferable from the viewpoint of composition controllability.

Examples of the antimony compound used as the catalyst include antimony trioxide, antimony pentoxide, antimony acetate, and antimony glycoxide. These are used alone or in combination of two or more. Among these antimony compounds, the antimony trioxide is especially preferable. From the viewpoint of the reaction rate and the economic viewpoint, the amount of antimony compound catalyst input at the time of polymerization is preferably 50 to 2,000 wt.ppm of the amount of resin, and more preferably 100 to 1,000 wt.ppm of the amount of resin.

Examples of the germanium compound used as the catalyst include: germanium oxide, such as germanium dioxide; germanium alkoxide, such as germanium tetraethoxide and germanium tetraisopropoxide; germanium hydroxide; alkali metal salt of germanium hydroxide; germanium glycolate; germanium chloride; and germanium acetate. These are used alone or in combination of two or more. Among these germanium compounds, the germanium dioxide is especially preferable. From the viewpoint of the reaction rate and the economic viewpoint, the amount of germanium dioxide catalyst input at the time of polymerization is preferably 50 to 2,000 wt.ppm of the amount of resin, and more preferably 100 to 1,000 wt.ppm of the amount of resin.

As the aromatic dicarboxylic acid, terephthalic acid is especially preferable. Other examples of the aromatic dicarboxylic acid include isophthalic acid, diphenyl dicarboxylic acid, and diphenoxy ethane dicarboxylic acid. Together with these aromatic dicarboxylic acids, aromatic oxycarboxylic acid (such as oxybenzoic acid) or aliphatic or alicyclic dicarboxylic acid (such as adipic acid, sebacic acid, and cyclohexane 1,4-dicarboxylic acid) may be used at a low rate (15% or less).

The diol is a low molecular weight glycol component forming an ester unit and may be a low molecular weight glycol having a carbon number of 2 to 10, and examples thereof include ethylene glycol, trimethylene glycol, tetramethylene glycol, hexanediol, decanediol, and cyclohexane dimethanol. Ethylene glycol, trimethylene glycol, and tetramethylene glycol are especially preferable since these are easily available.

As an alkyl group of the aromatic dialkyl dicarboxylate, a methyl group is preferable from the viewpoint of transesterification reactivity.

Regarding the viscosity of a solution of the high-molecular weight aromatic polyester, from the viewpoint of impact resistance, chemical resistance, and moldability of the resulting molded article, a logarithmic viscosity (IV) in a mixed solvent in which phenol/tetrachloroethane is 1/1 (weight ratio) at 25°C at a concentration of 0.5 g/dl is preferably 0.3 to 2.0, and further preferably 0.5 to 1.5.

### Aromatic Polyester Unit

The above-described aromatic polyester unit is a polymer or copolymer obtained from: an aromatic dicarboxylic acid or its ester-forming derivative; and a diol or its ester-forming derivative. The above-described aromatic polyester unit is typically an alternating polycondensate and is preferably at least one selected from the group consisting of polyethylene terephthalate unit, polybutylene terephthalate unit, and polypropylene terephthalate unit. Preferable specific examples of the aromatic polyester unit include a polyethylene terephthalate unit, a polyethylene terephthalate copolymer unit, a polybutylene terephthalate unit, a polybutylene terephthalate copolymer unit, a polypropylene terephthalate unit, and a polypropylene terephthalate copolymer unit. More preferably, the aromatic polyester unit is at least one selected from the group consisting of polyethylene terephthalate unit, polybutylene terephthalate, and polypropylene terephthalate unit.

### Modified Polyether Unit

The above-described modified polyether unit is a unit represented by the above general formula (1), and each of the numbers m and n of repeating units of OR⁹ unit and R¹⁰O unit in the general formula (1) is an integer of one or more. A number average of (m + n) is preferably 2 to 50, more preferably 10 to 50, and further preferably 18 to 50.

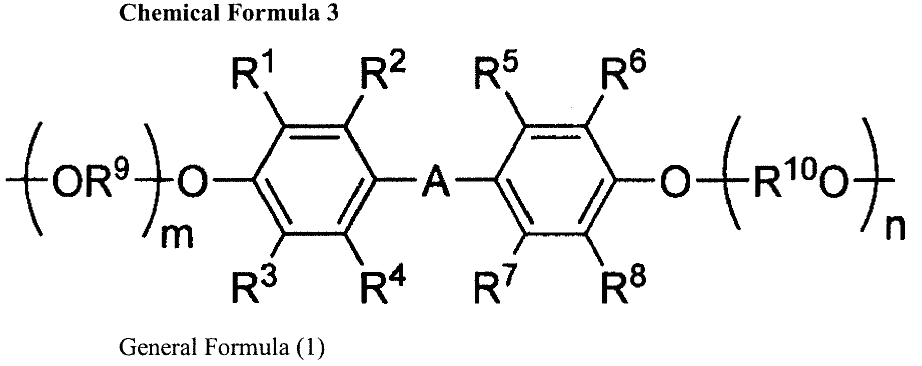

In this formula, -A- denotes -O-, -S-, -SO-, -SO₂-, -CO-, alkylene group having a carbon number of 1 to 20, or alkylidene group having a carbon number of 6 to 20. Each of R¹, R², R³, R⁴, R⁵, R⁶, R⁷, and R⁸ denotes hydrogen atom, halogen atom, or a monovalent hydrocarbon group having a carbon number of 1 to 5. Each of R⁹ and R¹⁰ denotes a divalent hydrocarbon group having a carbon number of 1 to 5. Each of m and n denotes the number of repeating units of the OR⁹ unit or the R¹⁰O unit and is an integer of one or more. The number average of m + n is 2 to 50.

As the modified polyether unit, a unit obtained by removing two terminal hydrogens from a compound represented by a general formula (2) below is preferable from the viewpoint that such unit is easily available. When (m + n) is two, the formula weight of the unit is 314. When (m + n) is 50, the formula weight of the unit is 2,426. Therefore, the molecular weight of the compound represented by the general formula (2) is preferably 316 to 2,430, more preferably 670 to 2,430, further preferably 1,020 to 2,430, and further preferably 1,330 to 2,000.

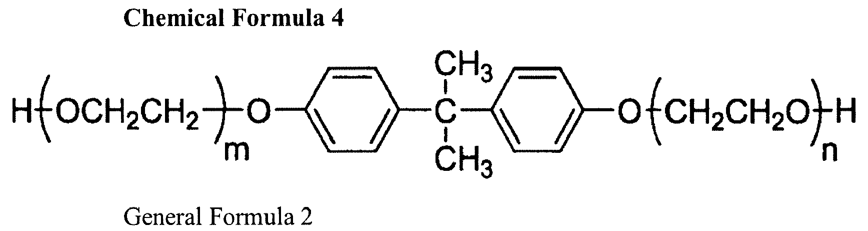

Among these crystalline polyester resins, polyethylene terephthalate, polypropylene terephthalate, polybutylene terephthalate, polyethylene-2,6-naphthalate, polybutylene naphthalate, poly 1,4-cyclohexylene dimethylene terephthalate, polyester-polyether copolymer, and the like are preferable from the viewpoint of moldability, a mechanical property, and the like. Further, polybutylene terephthalate, polyethylene terephthalate, and polyester-polyether copolymer are more preferable from the viewpoint that these are inexpensive and easily available.

A number average molecular weight of the thermoplastic resin (A) of the present invention is a value measured in such a manner that: polystyrene is used as standard; a solution containing the thermoplastic resin (A) at a concentration of 2.5 wt.% is prepared by dissolving the thermoplastic resin (A) in a mixed solvent in which a volume ratio between p-chlorophenol and toluene is 3 : 8; a high-temperature GPC (Viscotek:350 HT-GPC System) is used; a column temperature is 80°C; and a refractive index detector (RI) is used as a detector.

The number average molecular weight of each of the polybutylene terephthalate, the polyethylene terephthalate, and the polyester-polyether copolymer is preferably 12,000 to 70,000, more preferably 15,000 to 60,000, further preferably 16,000 to 55,000, and especially preferably 17,000 to 40,000. If the number average molecular weight of the above resin is less than 12,000, mechanical strength may be low. If the number average molecular weight of the above resin is more than 70,000, moldability deteriorates, and joining between the metal and the resin may become difficult.

The metal resin composite of the present invention may be produced in such a manner that: the thermally conductive resin composition is produced by melting and kneading the thermoplastic resin (A), the inorganic filler (B), and other component(s) according to need; and the injection molding of the thermally conductive resin composition is performed under the existence of the member made of the surface-treated metal. The number average molecular weight in the present invention may be measured before or after the melting and kneading or before or after the injection molding, but it is preferable that the number average molecular weight be measured after the injection molding.

### Inorganic Filler (B)

The inorganic filler (B) of the present invention is at least one selected from the group consisting of inorganic particles (B1) and inorganic fibers (B2) below.
(B1) Inorganic particles having thermal conductivity of 2 W/(m·K) or more and a volume average particle diameter of 1 to 700 µm
(B2) Inorganic fibers having thermal conductivity of 1 W/(m·K) or more, a number average fiber diameter of 1 to 50 µm, and a number average fiber length of 6 mm or less

### Inorganic Particles (B1)

Regarding the inorganic filler (B) of the present invention, the shape of the inorganic particle (B1) may be any shape except for a fiber shape. Examples of the shape of the inorganic particle (B1) include a scale-like shape, a flake shape, a plate shape, a spherical shape, an agglomerated particle shape, a tube shape, a wire shape, a rod shape, an irregular shape, a rugby ball shape, and a hexahedron shape. The shape of the inorganic particle (B1) is not especially limited but is preferably a scale-like shape, a spherical shape, a plate shape, or a fiber shape, and more preferably a scale-like shape or a spherical shape.

The thermal conductivity of the inorganic particle (B1) itself used in the present invention is 2 W/(m·K) or more, preferably 10 W/(m·K) or more, more preferably 30 W/(m·K) or more, further preferably 100 W/(m·K) or more, and especially preferably 150 W/(m·K). The upper limit of the thermal conductivity of the inorganic particle (B1) itself is not especially limited. The higher the upper limit of the thermal conductivity of the inorganic particle (B1) is, the better. However, the upper limit of the thermal conductivity of the inorganic particle (B1) is typically 3,000 W/(m·K) or less and preferably 2,500 W/(m·K) or less.

The metal resin composite of the present invention is integrally molded by injection molding. The volume average particle diameter of the inorganic particles (B1) contained in the composite is 1 to 700 µm, preferably 10 to 300 µm, more preferably 20 to 200 µm, and especially preferably 40 to 100 µm. If the volume average particle diameter of the inorganic particles (B1) is less than 1 µm, the thermal conductivity of the resin composition may deteriorate, and the joining strength between the metal member and the resin member may deteriorate. As the particle diameter increases, the thermal conductivity and the moldability improve, and the joining between the metal member and the resin member tends to become easy. However, if the particle diameter exceeds 700 µm, the strength of the resin composition may deteriorate. In the present invention, the measurement of the volume average particle diameter is performed at a room temperature using a laser diffraction · scattering type particle size distribution measuring device Microtrac after the inorganic particles are dispersed in a water solvent, and ultrasonic waves are applied for 30 seconds.

The aspect ratio of the inorganic particle (B1) having a shape other than a spherical shape is not especially limited but is preferably 5 or more, more preferably 10 or more, and further preferably 21 or more. The higher the upper limit of the aspect ratio is, the better. The upper limit of the aspect ratio is not especially limited but is in a range of preferably 3,000 or less, more preferably 1,000 or less, and further preferably 500 or less. As the aspect ratio increases, the thermal conductivity and the moldability improve, and the joining between the metal member and the resin member becomes easy.

### Inorganic Fibers (B2)

Regarding the inorganic filler (B) of the present invention, the shape of the inorganic fiber (B2) is a fiber shape. In the case of the fiber shape, not only the thermal conductivity but also the strength of the resin member can be improved.

The number average fiber diameter of the inorganic fibers (B2) contained in the metal resin composite of the present invention is 1 to 50 µm, preferably 3 to 30 µm, and more preferably 5 to 20 µm. The number average fiber length of the inorganic fibers (B2) contained in the metal resin composite of the present invention is preferably 6 mm or less, more preferably 4 mm or less, further preferably 3 mm or less, and especially preferably 2 mm or less. If the number average fiber diameter is less than 1 µm, the improvement of the strength may become small. If the number average fiber diameter is more than 50 µm, the moldability may deteriorate. If the number average fiber length is more than 6 mm, the moldability may deteriorate. In the present invention, the number average fiber diameter and the number average fiber length are determined in such a manner that: fiber diameters and fiber lengths of 100 inorganic fibers are measured by electron microscopic observation; and an average value of the fiber diameters and an average value of the fiber lengths are calculated.

The thermal conductivity of the inorganic fiber (B2) itself used in the present invention is 1 W/(m·K) or more, preferably 5 W/(m·K) or more, more preferably 10 W/(m·K) or more, further preferably 50 W/(m·K) or more, and especially preferably 100 W/(m·K). The upper limit of the thermal conductivity of the inorganic fiber (B2) itself is not especially limited. The higher the upper limit of the thermal conductivity of the inorganic fiber (B2) is, the better. The upper limit of the thermal conductivity of the inorganic fiber (B2) is typically 3,000 W/(m·K) or less and further preferably 2,500 W/(m·K) or less.

The inorganic filler (B) of the present invention is not especially limited as long as it satisfies the above conditions. When the metal resin composite of the present invention is used in an application that does not especially require an electrical insulation property, a metal based compound, an electrically conductive carbon compound, or the like is preferably used as the inorganic filler. Among these, preferable examples of the inorganic filler include: electrically conductive carbon materials such as graphite, carbon fiber, and graphene; electrically conductive metal powder, i.e., fine particles of various metals; electrically conductive metal fibers, i.e., fibers of various metals; various ferrites such as soft magnetic ferrite; and metal oxides such as zinc oxide, since these excel in thermal conductivity. Among these, graphite and carbon fiber are preferable since each of these has high thermal conductivity, is relatively low in cost, and has low specific gravity. It should be noted that an inorganic filler having an electrical insulation property may be used at the same time.

When the metal resin composite of the present invention is used in an application that requires the electrical insulation property, an inorganic filler having the electrical insulation property is preferably used as the inorganic filler (B). Specifically, the electrical insulation property herein denotes an electrical resistivity of 1 Ω·cm or more, preferably 10 Ω·cm or more, more preferably 10⁵ Ω·cm or more, further preferably 10¹⁰ Ω·cm or more, and most preferably 10¹³ Ω·cm or more. The upper limit of the electrical resistivity is not especially limited but is typically 10¹⁸ Ω·cm or less. It is preferable that the electrical insulation property of a molded body produced from the thermally conductive resin composition of the present invention be also within the above range.

Specific examples of the inorganic filler having the electrical insulation property include: metal oxide such as aluminum oxide, magnesium oxide, silicon oxide, beryllium oxide, copper oxide, and cuprous oxide; metal nitride such as boron nitride, aluminum nitride, and silicon nitride; metal carbide such as silicon carbide; metal carbonate such as magnesium carbonate; insulating carbon material such as diamond; metal hydroxide such as aluminum hydroxide and magnesium hydroxide; wollastonite; talc; and glass fiber. These may be used alone or in combination. Among these, talc, hexagonal boron nitride, magnesium oxide, and glass fiber are preferable from the viewpoint of the thermal conductivity, easy availability, and easy handleability.

In the present invention, "thermal conductivity in a surface direction (In-Plane thermal conductivity)" denotes the thermal conductivity in a direction in which melted resin flows during injection molding. Further, the thermal conductivity in a direction vertical to the direction in which the resin flows is referred to as "thermal conductivity in a thickness direction (Thru-Plane thermal conductivity)."

The thermal conductivity of the thermally conductive resin composition of the present invention in the surface direction (In-Plane thermal conductivity) is 1 W/(m·K) or more, preferably 3 W/(m·K) or more, more preferably 5 W/(m·K) or more, and further preferably 10 W/(m·K) or more. The upper limit of the thermal conductivity of the thermally conductive resin composition of the present invention in the surface direction (In-Plane thermal conductivity) is not especially limited. The larger the upper limit of the thermal conductivity of the thermally conductive resin composition of the present invention in the surface direction (In-Plane thermal conductivity) is, the better. The upper limit of the thermal conductivity of the thermally conductive resin composition of the present invention in the surface direction (In-Plane thermal conductivity) is typically 100 W/(m·K) or less.

The thermal conductivity of the thermally conductive resin composition of the present invention in the thickness direction (Thru-Plane thermal conductivity) is not especially limited. The higher the thermal conductivity of the thermally conductive resin composition of the present invention in the thickness direction (Thru-Plane thermal conductivity) is, the better. The thermal conductivity of the thermally conductive resin composition of the present invention in the thickness direction (Thru-Plane thermal conductivity) is preferably 0.5 W/(m·K) or more, more preferably 0.8 W/(m·K) or more, further preferably 1 W/(m-K) or more, and especially preferably 1.2 W/(m·K) or more.

When the entire thermally conductive resin composition of the present invention is regarded as 100 wt.%, the content of the thermoplastic resin (A) in the thermally conductive resin composition is preferably 20 to 95 wt.%, more preferably 30 to 80 wt.%, further preferably 40 to 75 wt.%, and especially preferably 40 to 70 wt.%. If the content of the thermoplastic resin (A) is less than 20 wt.%, joining with the metal member may become difficult. If the content of the thermoplastic resin (A) is more than 95 wt.%, the thermally conductive resin composition itself may not have an excellent heat radiation property.

When the entire thermally conductive resin composition is regarded as 100 wt.%, the content of the inorganic filler (B) is preferably 5 to 80 wt.%, more preferably 20 to 70 wt.%, further preferably 25 to 60 wt.%, and especially preferably 30 to 60 wt.%.

The specific gravity of the thermally conductive resin composition of the present invention is preferably 1.2 to 2.1, more preferably 1.4 to 1.9, and further preferably 1.5 to 1.8. If the specific gravity is less than 1.2, the thermal conductivity may not be adequately obtained, and the heat radiation property may be inadequate.

When graphite is used as the inorganic particle (B1), a fixed carbon content of the graphite is preferably 98 mass% or more, more preferably 98.5 mass%, and further preferably 99 mass% or more. If the fixed carbon content of the graphite is less than 98 mass%, the thermal conductivity may deteriorate. The fixed carbon content remains unchanged before and after the melting and kneading and before and after the molding. The fixed carbon content can be measured according to JIS M8511.

As the graphite in the metal resin composite, spherical graphite or flacked graphite is preferable, and the aspect ratio of the flacked graphite is preferably 21 or more. The higher the upper limit of the aspect ratio is, the better. The upper limit of the aspect ratio is not especially limited but is in a range of preferably 10,000 or less, more preferably 5,000 or less, and further preferably 3,000 or less. The aspect ratio can be measured in such a manner that: lengths that are a maximum diameter and thickness of a graphite particle are measured with an electron microscope; and the maximum diameter is divided by the thickness.

In the thermally conductive resin composition of the present invention, the larger the volume average particle diameter of the inorganic particles (B1) before the melting and kneading is, the better. The volume average particle diameter of the inorganic particles (B1) before the melting and kneading is preferably 10 to 700 µm, more preferably 20 to 650 µm, further preferably 40 to 500 µm, and especially preferably 201 to 40 µm. Typically, the inorganic particles tend to be crushed at the time of the melting and kneading or the molding. Therefore, the larger the volume average particle diameter of the inorganic particles (B1) before the melting and kneading is, the larger the volume average particle diameter of the inorganic particles (B1) after the melting and kneading or the molding is maintained. In this case, the thermal conductivity and the moldability improve, and the joining between the metal member and the resin member becomes easy.

The graphite used as the inorganic particle (B1) in the present invention may be any of natural graphite and artificial graphite or may be a combination of natural graphite and artificial graphite. The natural graphite is preferable from the viewpoint that the natural graphite is available at low cost. Further, the graphite used as the inorganic particles (B1) in the present invention may be any of α-graphite and β-graphite or a combination of α-graphite and β-graphite.

A particle size distribution of the inorganic particles (B1) is not especially limited. However, a ratio D₈₀/D₂₀ of a particle diameter D₈₀ when a cumulative volume obtained by measuring the particle size distribution is 80% to a particle diameter D₂₀ when the cumulative volume is 20% is preferably 1 to 20, more preferably 1 to 10, and further preferably 1 to 5.

In addition to the inorganic filler (B), the thermally conductive resin composition of the present invention may further contain the other thermally conductive filler. The shape of the other thermally conductive filler is not especially limited. Examples of the shape of the other thermally conductive filler include various shapes such as a scale-like shape, a fiber shape, a flake shape, a plate shape, a spherical shape, a particle shape, a fine particle shape, a nano-particle shape, an agglomerated particle shape, a tube shape, a nanotube shape, a wire shape, a rod shape, an irregular shape, a rugby ball shape, a hexahedron shape, a combined particle shape obtained by a combination of a large particle and a fine particle, and a liquid form.

Specific examples of the other thermally conductive filler include: a metal filler, such as aluminum and nickel; a low melting point alloy having a liquidus temperature of 300°C or more and a solidus temperature of 150°C or more and 250°C or less; metal oxide, such as aluminum oxide, magnesium oxide, silicon oxide, beryllium oxide, copper oxide, and copper suboxide; metal nitride, such as aluminum nitride and silicon nitride; metal carbide, such as silicon carbide; metal carbonate, such as magnesium carbonate; an insulating carbon material, such as diamond; metal hydroxide, such as aluminum hydroxide and magnesium hydroxide; alumina; boron nitride; glass fiber; carbon fiber; potassium titanate whisker; silicon nitride fiber; carbon nanotube; talc; and wollastonite. The above thermally conductive filler may be a natural filler or a synthetic filler. A production area and the like of the natural filler are not especially limited and may be selected suitably.

The amount of the other thermally conductive filler added is not especially limited. The thermal conductivity can be improved as the amount of the other thermally conductive filler added increases.

A known filler other than the above thermally conductive filler may be added to the thermally conductive resin composition of the present invention according to a purpose. Examples of the filler other than the thermally conductive filler include: inorganic fibers, such as diatomaceous earth powder, basic magnesium silicate, baked clay, fine silica powder, quartz powder, crystalline silica, kaolin, antimony trioxide, fine mica powder, molybdenum disulfide, rock wool, ceramic fiber, and asbestos; and glass filler, such as glass fiber, glass powder, glass cloth, and molten silica. By using these fillers, it is possible to improve the properties (such as the thermal conductivity, the mechanical strength, and the abrasion resistance, which are preferable for utilizing the resin composition) of the resin composition. In addition, an organic filler may also be added to the thermally conductive resin composition of the present invention according to need. Examples of the organic filler include: synthetic fiber, such as paper, pulp, wood, polyamide fiber, aramid fiber, and boron fiber; and resin powder, such as polyolefin powder.

To increase the adhesive property of an interface between the resin and the filler and facilitate workability, the filler used in the present invention may be subjected to a surface treatment using various surface treatment agents, such as silane agent, stearic acid, and acrylic monomer.

The surface treatment agent is not especially limited, and known agents such as a silane coupling agent and a titanate coupling agent may be used. Among these, an epoxy group-containing silane coupling agent (such as epoxysilane), an amino group-containing silane coupling agent (such as aminosilane), and polyoxyethylene silane are preferable since these hardly deteriorate the physical property of the resin. The surface treatment method for the filler is not especially limited, and normal treatment methods may be utilized.

The thermally conductive resin composition of the present invention may be alloyed with any known resin, such as epoxy resin, polyolefin resin, bismaleimide resin, polyimide resin, polyether resin, phenol resin, silicone resin, polycarbonate resin, polyamide resin, polyester resin, fluorocarbon resin, acryl resin, melamine resin, urea resin, or urethane resin.

Any component as an additive other than the above resin and filler may be added to the thermally conductive resin composition of the present invention according to a purpose without deteriorating the effects of the present invention. Examples of such additive include a reinforcing agent, a thermal stabilizer, an antioxidant, an ultraviolet absorber, an age resister, a thickener, a release agent, a plasticizer, a coupling agent, a flame retardant, a flameproofing agent, an antibacterial agent, a coloring agent, and other auxiliary agents. When the thermoplastic resin (A) is 100 parts by weight, the amount of additives used is preferably 0 to 20 parts by weight in total.

Examples of the thermal stabilizer include phosphites, hindered phenols, and thioethers. These may be used alone or in combination of two or more.

Examples of the antioxidant include phosphites, hindered amines, hydroquinones, hindered phenols, and sulfur-containing compounds. These may be used alone or in combination of two or more.

Examples of the ultraviolet absorber include benzophenones, benzotriazoles, salicylate esters, and metallic complex salts. These may be used alone or in combination of two or more.

Examples of the flame retardant include an organic flame retardant, an inorganic flame retardant, and a reactive flame retardant. These may be used alone or in combination of two or more.

Examples of the organic flame retardant include: halogen-based flame retardants, such as a brominated epoxy compound, a brominated alkyl triazine compound, a brominated bisphenol epoxy resin, a brominated bisphenol phenoxy resin, a brominated bisphenol polycarbonate resin, a brominated polystyrene resin, a brominated crosslinked polystyrene resin, a brominated bisphenol cyanurate resin, a brominated polyphenylene ether, a brominated bismaleimide, decabromodiphenyl oxide, tetrabromobisphenol A, and its oligomer; phosphorous flame retardants, such as phosphoester (trimethyl phosphate, triethyl phosphate, tripropyl phosphate, tributyl phosphate, tripentyl phosphate, trihexyl phosphate, tricyclohexyl phosphate, triphenyl phosphate, tricresyl phosphate, trixylenyl phosphate, cresyl diphenyl phosphate, dicresyl phenyl phosphate, dimethyl ethyl phosphate, methyl dibutyl phosphate, ethyl dipropyl phosphate, and hydroxy phenyl diphenyl phosphate), compounds obtained by modifying the phosphoester with various substituents, various condensed phosphoester compounds, and phosphazene derivatives containing phosphorus element and nitrogen element; and polytetrafluoroethylene. These may be used alone or in combination of two or more.

Examples of the inorganic flame retardant include aluminum hydroxide, antimony oxide, magnesium hydroxide, zinc borate, zirconium compound, molybdenum compound, zinc stannate, guanidine salt, silicone compound, and phosphazene compound. These may be used alone or in combination of two or more.

Examples of the reactive flame retardant include tetrabromobisphenol A, dibromophenol glycidyl ether, brominated aromatic triazine, tribromophenol, tetrabromophthalate, tetrachlorophthalic anhydride, dibromoneopentylglycol, poly(pentabromo benzil polyacrylate), chlorendic acid (HET acid), chlorendic anhydride (HET anhydride), brominated phenol glycidyl ether, dibromocresyl glycidyl ether, and an organic phosphorous flame retardant represented by a general formula (3) below (in this formula, n is an integer of 2 to 20). These may be used alone or in combination of two or more.

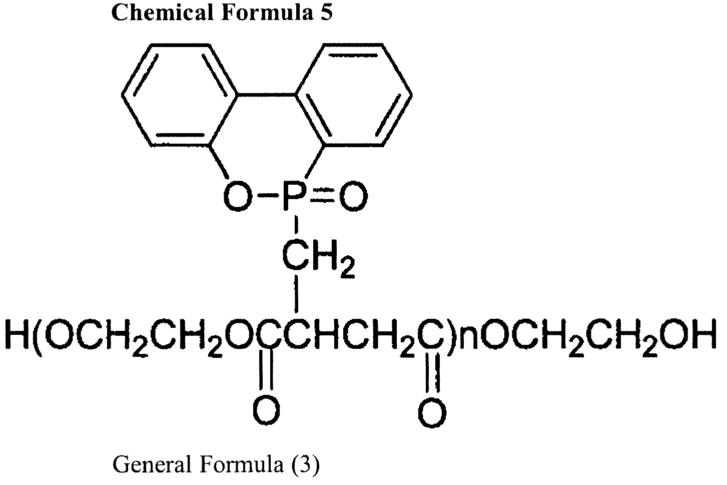

When adding the flame retardant to the composition of the present invention, it is preferable to also add a flame retardant promoter. Examples of the flame retardant promoter include: antimony compounds, such as bianitmony trioxide, bianitmony tetroxide, bianitmony pentoxide, antimony sodiate, and antimony tartrate; zinc borate; barium metaborate; hydrated alumina; zirconium oxide; ammonium polyphosphate; tin oxide; and iron oxide. These may be used alone or in combination of two or more. Further, silicone oil may be added to improve the flame retardancy.

Examples of the age resister include a naphthylamine compound, a diphenylamine compound, a p-phenylenediamine compound, a quinoline compound, a hydroquinone derivative compound, a monophenol compound, a bisphenol compound, a trisphenol compound, a polyphenol compound, a thiobisphenol compound, a hindered phenol compound, a phosphite compound, an imidazole compound, a dithiocarbamate nickel salt compound, and a phosphate compound. These may be used alone or in combination of two or more.

Examples of the plasticizer include: phthalic esters, such as dimethyl phthalate, diethyl phthalate, dibutyl phthalate, diisobutyl phthalate, dioctyl phthalate, butyl octyl phthalate, di-(2-ethylhexyl) phthalate, diisooctyl phthalate, and diisodecyl phthalate; fatty acid esters, such as dimethyl adipate, diisobutyl adipate, di-(2-ethylhexyl) adipate, diisooctyl adipate, diisodecyl adipate, octyl decyl adipate, di-(2-ethylhexyl) azelate, diisooctyl azelate, diisobutyl azelate, dibutyl sebacate, di-(2-ethylhexyl) sebacate, and diisooctyl sebacate; trimellitic acid esters, such as trimellitic acid isodecyl ester, trimellitic acid octyl ester, trimellitic acid n-octyl ester, and trimellitic acid isononyl ester; di-(2-ethylhexyl) fumarate; diethylene glycol monooleate; glyceryl monoricinoleate; trilauryl phosphate; tristearyl phosphate; tri-(2-ethylhexyl) phosphate; epoxidized soybean oil; and polyether ester. These may be used alone or in combination of two or more.

Examples of the antibacterial agent include: inorganic antibacterial agents, such as a zeolite antibacterial agent (silver zeolite, silver-zinc zeolite, etc.), a silica gel antibacterial agent (silver complex-silica gel, etc.), a glass antibacterial agent, a calcium phosphate antibacterial agent, a zirconium phosphate antibacterial agent, a silicate antibacterial agent (silver-aluminosilicate magnesium, etc.), a titanium oxide antibacterial agent, a ceramic antibacterial agent, and a whisker antibacterial agent; organic antibacterial agents, such as a formaldehyde releasing agent, a halogenated aromatic compound, a load propargyl derivative, a thiocyanate compound, an isothiazolinone derivative, a trihalomethylthio compound, quaternary ammonium salt, a biguanide compound, aldehydes, phenols, pyridine oxide, carbanilide, diphenyl ether, carboxylic acid, and an organic metal compound; an inorganic-organic hybrid antibacterial agent; and a natural antibacterial agent. These may be used alone or in combination of two or more.

Examples of the coloring agent include organic dye, inorganic pigment, and organic pigment. These may be used alone or in combination of two or more.

A method of producing the thermoplastic resin composition of the present invention is not especially limited. For example, the thermoplastic resin composition of the present invention may be produced in such a manner that after the above components, additives, and the like are dried, melting and kneading are performed by a melt kneader, such as a single-screw extruder or a twin-screw extruder. A kneading temperature is determined based on the type of the thermoplastic resin (A). Further, if a component added is liquid, it may be added to the melt kneader by a liquid supply pump or the like in the middle of the production.

To obtain the insulation property, the metal resin composite of the present invention may further include a member made of ceramics or a member made of resin or resin composition having the insulation property. It is preferable that the metal resin composite of the present invention be combined with the member made of the resin or resin composition having the insulation property since the insulation property can be obtained at low cost.

This combining method is not especially limited. Examples of the combining method include: a method using integral molding such as insert molding or two-color molding; and a method of separately producing an insulating member and combining the insulating member with the metal resin composite by an adhesive, vibration welding, ultrasonic welding, heat seal, or the like.

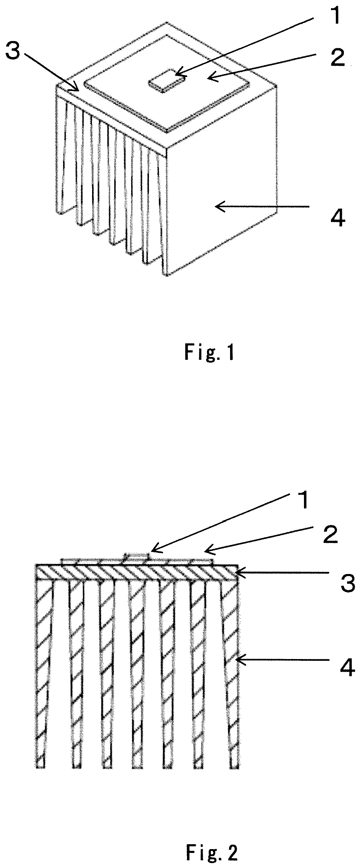

The shape of the metal resin composite of the present invention is not especially limited. However, the shape of the metal resin composite of the present invention is preferably designed to have a shape of a heat sink including a fin explained below. One typical example of the heat sink is shown in Figs. 1 and 2. Fig. 1 is a perspective view, and Fig. 2 is a sectional view.

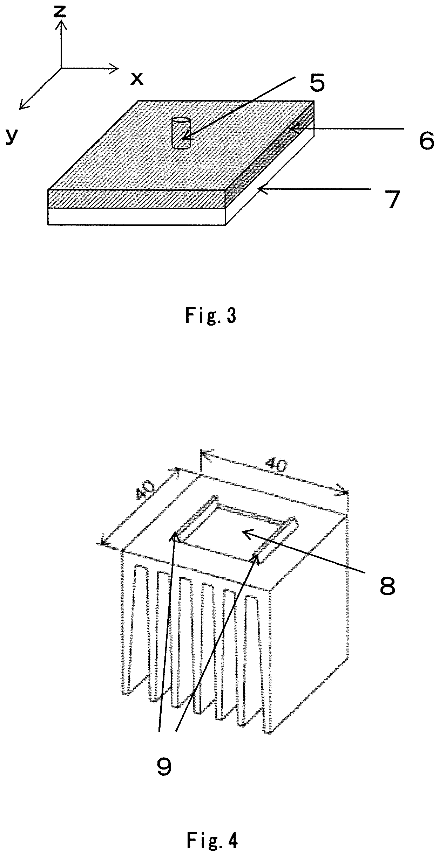

The heat sink shown in Figs. 1 and 2 includes a heat sink board 3 and a heat sink fin 4. A circuit substrate 2 and an LED module 1 are arranged on an upper surface of the board 3. The heat sink fin 4 includes a plurality of flat plate-shaped members arranged in parallel with one another. Each of the flat plate-shaped members extends in a vertical direction from a lower surface of the heat sink board 3. According to this heat sink, the thermal conductivity of the heat sink board portion in a thickness direction (Thru-Plane thermal conductivity) is made high. With this, the heat of the LED module that is a heat generating body is efficiently transferred to the fin portion. Thus, the heat radiation property can be improved. When producing the heat sink, it is preferable to design the heat sink such that resin is supplied into a die cavity through a gate (inlet) that is narrow relative to the thickness of the heat sink, that is, it is preferable to design the heat sink such that a ratio (heat sink thickness/gate mark thickness) of the thickness of the heat sink to the thickness of a gate mark (shown by reference sign 5 in Fig. 3) formed at the heat sink is 2 or more. The ratio of the thickness of the heat sink to the thickness of the gate mark is more preferably 3 or more and further preferably 5 or more. When the ratio of the thickness of the heat sink to the thickness of the gate mark is 2 or more, the inorganic filler (B) can be oriented in the thickness direction of the heat sink, and therefore, the thermal conductivity of the heat sink in the thickness direction (Thru-Plane thermal conductivity) can be efficiently increased. This product design is not limited to the shape of the heat sink and is applicable to any shape regardless of whether or not a fin is provided. The thickness of the gate mark herein may denote the diameter of the gate mark. The thickness of the heat sink herein denotes a thickness other than the thickness of the fin portion and is not especially limited but is preferably the thickness of the heat sink board portion.

The type of the gate is not especially limited. Examples of the gate include a direct gate, a side gate, a pinpoint gate, a film gate, a disc gate, a ring gate, a fan gate, a tab gate, a submarine gate, and a hot runner gate. The direct gate, the pinpoint gate, the film gate, and the like are preferable from the viewpoint that the inorganic filler (B) is easily oriented in the thickness direction of the heat sink. Further, the direct gate is preferable from the viewpoint that the melted resin easily flows into the die in a state where the melted resin hardly solidifies as much as possible.

The position of the gate mark is not especially limited. From the viewpoint that the metal member and the resin member can be more easily joined to each other, the position shown in Fig. 3 is preferable. To be specific, it is preferable to set the position of the gate mark such that: a direction (-z direction) of the recess formed on the surface of the metal and an inflow direction (-z direction) of the melted resin coincide with each other; and the melted resin can flow into the die, and at the same time, collide with the surface of the metal. With this, the melted resin can densely flow into the fine recesses on the surface of the metal before the melted resin solidifies. Further, excellent joining can be achieved by the anchor effect.

The number of gate marks is not especially limited. From the viewpoint of the heat radiation property and the moldability, the number of gate marks is preferably two or more. When the number of gate marks is two or more, the thermal conductivity of a weld portion in the thickness direction (Thru-Plane thermal conductivity) can be increased, the weld portion being generated when supplying the resin. Thus, the heat of the heat generating body can be efficiently transferred to the fin. When providing two or more gate marks, it is preferable that the gate marks be provided symmetrically relative to the heat sink as much as possible from the viewpoint of the moldability.

The metal resin composite of the present invention is formed such that the member made of the thermally conductive resin composition and the member made of the surface-treated metal contact each other and are joined to each other. The position of the metal member in the metal resin composite of the present invention is not especially limited. From the viewpoint that the heat of the heat generating body can be efficiently radiated in such a manner that the heat of the heat generating body is diffused by the metal member and is then radiated by the member made of the thermally conductive resin composition, it is preferable that the metal member be provided at a heat-receiving surface portion of the metal resin composite of the present invention.

The position of the heat generating body is not especially limited. Due to the above reason, it is preferable that the heat generating body be provided on the surface of the metal member.

The shape of the metal resin composite of the present invention is not especially limited but may be the shape of the heat sink including the fin. In this case, it is preferable that the fin be provided on the metal member.

Since the metal resin composite of the present invention has an excellent heat radiation property, excellent moldability, and low specific gravity, the metal resin composite of the present invention is suitable for heat radiation housings, heat radiation chassis, and heat sinks. The metal resin composite of the present invention can be used such that, for example, the heat generating body is provided on an outer surface thereof, or the heat generating body is accommodated therein.

The heat generating body may be an object having a heat generating property or an object that is externally heated to generate heat. Typical heat generating bodies are heat generating parts and apparatuses (devices), and examples thereof include: electronic parts such as LDs (laser diodes) and ICs (integrated circuits); electronic devices utilizing computers, such as personal computers, word processors, and video games; engine control units (ECUs) that are computers each configured to determine a fuel injection quantity and an ignition timing based on information such as the amount of air taken into an engine of an automobile and the opening degree of a throttle; heat sinks for LED lamp lights, inverters, and automobile lamps; various heat radiation housings, such as housings, coils, bobbins, connectors, bus bars, power steerings, car CCD cameras, which require the heat radiation property.

The heat radiation chassis is used as a key chassis or a sub chassis for releasing heat from the heat generating body. A typical example of the heat generating body is a heat generating part that generates heat, and specific examples thereof include electronic parts, such as LDs and ICs in electric/electronic products such as mobile phones and TVs. When using such heat generating body, the heat generating body is mounted on (fixed to) the heat radiation chassis, or the heat generating body is arranged in contact with or close to the heat radiation chassis without being fixed to the heat radiation chassis. Further, the heat radiation chassis is preferably used as an LED (light emitting diode) lighting package. The heat radiation chassis is preferably used as a heat sink, a socket, or the like for cooling an LED module and is especially suitable as a car LED lamp heat sink.

The car LED lamp heat sink may be any heat sink as long as it includes a board and a fin. The car LED lamps can be roughly classified into interior lamps and exterior lamps. Examples of the interior lamps include a room lamp and a map lamp, and examples of the exterior lamps include a rear lamp, a front lamp, and a head lamp. Specifically, examples of the rear lamp include a tail lamp, a stop lamp, a rear turn signal lamp, a rear fog lamp, a high mount stop lamp, a back lamp, and a number plate lamp, and examples of the front lamp include a front fog lamp, a front turn signal lamp, a front positioning lamp, a side turn signal lamp, a day lamp, and a fashion lamp. The LED lamp heat sink of the present invention is suitably used for the rear lamp, the front lamp, and the head lamp among the above car LED lamps since each of the rear lamp, the front lamp, and the head lamp uses a high brightness LED module and requires the heat radiation property. Further, the LED lamp heat sink of the present invention is preferably used for the tail lamp, the stop lamp, the fog lamp, the positioning lamp, the turn signal lamp, the day lamp, and the head lamp.

Power consumption of each LED in the car LED lamp varies depending on use. Further, a plurality of LED modules may be used. Each of the rear lamp and the front lamp uses an LED module of typically 0.1 to 15 W, preferably 0.1 to 10 W, more preferably 0.1 to 8 W, further preferably 0.1 to 5 W, and especially preferably 0.1 to 3 W. Further, the head lamp uses an LED module of 1 W or more, preferably 5 to 40 W, more preferably 10 to 30 W, further preferably 10 to 25 W, and especially preferably 10 to 20 W.

The size of the car LED lamp heat sink is not especially limited. Depending on the type of a lamp to be used, the power consumption of the LED varies, and therefore, the necessary size of the heat sink for heat radiation varies.

The length of a longest side of the heat sink for the rear lamp is typically 100 mm or less, preferably 70 mm or less, more preferably 50 mm or less, and further preferably 40 mm or less. The length of a longest side of the heat sink for the front lamp is typically 200 mm or less, preferably 120 mm or less, more preferably 80 mm or less, and further preferably 50 mm or less. The length of a longest side of the heat sink for the head lamp is typically 300 mm or less, preferably 200 mm or less, more preferably 100 mm or less, and further preferably 80 mm or less.

As the size of the heat sink decreases, the weight of the heat sink can be reduced, but the required heat radiation property of the heat sink increases. Therefore, the degree of freedom of the shape of the heat sink is required. On this account, the thermoplastic resin composition of the present invention having excellent moldability is suitable and is suitably used for rear lamps which require small heat sinks.

The thickness of the heat sink board portion is not especially limited but is preferably 10 mm or less, more preferably 5 mm or less, further preferably 3 mm or less, and especially preferably 2 mm or less. If the thickness of the board portion is more than 10 mm, the heat of the LED module may not be efficiently transferred to the heat sink fin.

The height of the heat sink fin portion is not especially limited. From the viewpoint that the heat radiation property can be improved, the higher the height of the heat sink fin portion is, the better. In this case, it is preferable that the thermal conductivity of the fin portion in the surface direction (In-Plane thermal conductivity) be higher than the thermal conductivity of the board portion in the surface direction (In-Plane thermal conductivity). To realize this, the shape of the heat sink is preferably designed such that a ratio of the thickness of the heat sink fin portion to the thickness of the heat sink board portion is one or less. If the thickness of the fin is not uniform, the ratio is calculated by adopting the thickness of a root portion of the fin.

The metal resin composite of the present invention is produced in such a manner that: the member made of the surface-treated metal is placed in the die; and the thermally conductive resin composition flows into the die by injection molding. Molding conditions are not especially limited, but molding conditions described below are preferable since joining is more easily performed.

The higher the temperature of the melted resin is, the better. The temperature of the melted resin is not less than a temperature higher than the melting point of the thermoplastic resin (A) by preferably 10°C, more preferably by 20°C, and further preferably by 30°C.
Further, the higher the temperature of the die is, the better.

It is preferable that the metal member placed in the die be heated in advance to have a temperature equal to the temperature of the die. Further, the longer a time from when the metal member is placed in the die until when the melted resin flows into the die is, the better. The time from when the metal member is provided in the die until when the melted resin flows into the die is preferably 5 seconds or more, more preferably 10 seconds or more, and further preferably 20 seconds or more. By performing molding under these conditions, the flowability of the melted resin improves, and the solidification of the resin in the die delays. Therefore, the resin easily flows into the fine holes on the surface of the metal, and joining is more easily performed.

The metal member and the resin member in the metal resin composite of the present invention are joined to each other. To more strongly fix the metal, the joining may be performed by also using a fixing method, such as vibration welding, ultrasound welding, or heat seal. The vibration frequency when performing the vibration welding is preferably about 100 to 300 Hz, and the vibration frequency when performing the ultrasonic welding is preferably 10 to 50 kHz. Further, the total number of vibrations in the vibration welding is preferably 300 to 10,000, and the total number of vibrations in the ultrasound welding is preferably 10,000 to 150,000.

The metal resin composite of the present invention excels in emissivity. The emissivity in the present invention is the emissivity of the molded body measured using an emissivity measuring instrument and is preferably 0.65 or more, more preferably 0.75 or more, and further preferably 0.8 or more.

### EXAMPLES

Next, the present invention will be explained in more detail using Production Examples, Examples, and Comparative Examples. However, the present invention is not limited to these Examples.

Raw material components used for preparing the resin composition are shown below.

### Thermoplastic resin (A)

Polyethylene terephthalate (A-1): Novapex PBKII (product name) produced by Mitsubishi Chemical Corporation, Number average molecular weight of 28,000

Polyethylene terephthalate (A-2): KS710B-8S (product name) produced by Kuraray Co., Ltd., Number average molecular weight of 61,000

Polybutylene terephthalate (A-3): Novaduran 5008L (product name) produced by Mitsubishi Engineering-Plastics Corporation, Number average molecular weight of 19,000

Polyester-polyether copolymer (A-4): The polyester-polyether copolymer used herein was produced by a method below. To be specific, the polyester-polyether copolymer was prepared in such a manner that: 70 parts by weight of polyethylene terephthalate (PET) (IV = 0.65) produced by an antimony catalyst and having an antimony metal concentration of 200 wt.ppm, antimony trioxide that is 160 ppm relative to PET and polyether, 0.2 parts by weight of antioxidant (Irganox 1010 produced by Ciba Specialty Chemicals), and 30 parts by weight of polyether that is Bisol 18EN explained below were put in a reactor including a stirrer and a gas discharge port; the mixture was maintained at 270°C for two hours; pressure reduction was performed by a vacuum pump; and the mixture was maintained at one torr for three hours and then taken out. The number average molecular weight of the obtained polyester-polyether copolymer was 25,400. In the Bisol 18EN, the number average of (m + n) in the general formula (2) is 18.

Polyamide based resin (A-5): nylon 6, A1020BRL (product name) produced by Unitika Ltd.

Polyphenylene sulfide based resin (A-6): DURAFIDE W-220A (product name) produced by Polyplastics Co., Ltd.

### Inorganic particles (B1)

Flacked graphite (B1-1): CPB-80 (product name) produced by Chuetsu Graphite Works Co., Ltd., Volume average particle diameter of 300 µm, Fixed carbon content of 99.9 wt.%, Aspect ratio of 100

Flacked graphite (B1-2): BF-40AK (product name) produced by Chuetsu Graphite Works Co., Ltd., Volume average particle diameter of 50 µm, Fixed carbon content of 99.9 wt.%, Aspect ratio of 30

### Inorganic fibers (B2)

Glass fiber: T187H/PL (product name) produced by Nippon Electric Glass Co., Ltd., Thermal conductivity of 1.0 W/(m·K), Number average fiber diameter of 13 µm, Number average fiber length of 3.0 mm

Flame retardant (D): brominated flame retardant SAYTEX7010P (product name) produced by Albemarle Corporation

Flame retardant promoter (E): antimony trioxide PATOX-P (product name) produced by Nihon Seiko Co., Ltd.

### Metal Surface Treatment Method

A plate-shaped part having an outer size of 20 mm × 20 mm and a thickness of 1 mm and made of an aluminum alloy A5052 (defined in JIS H4040:2006) was subjected to the below-described metal surface treatment.

### Treatment 1

An aqueous solution containing a commercially available aluminum degreasing agent "NE-6 (produced by Meltex Inc., Tokyo, Japan)" at a concentration of 15% was prepared, and the temperature of the solution was adjusted to 75°C. The aluminum alloy plate was immersed in this degreasing agent aqueous solution for five minutes and was then washed with water. Next, an aqueous solution containing a hydrochloric acid at a concentration of 1% was prepared in a different tank, and the temperature of the solution was adjusted to 40°C. The aluminum alloy plate was immersed in this solution for one minute and was then washed with water.

Next, an aqueous solution containing caustic soda at a concentration of 1% was prepared in a different tank, and the temperature of the solution was adjusted to 40°C. The aluminum alloy plate was immersed in this solution for one minute and was then washed with water. Next, an aqueous solution containing a hydrochloric acid at a concentration of 1% was prepared in a different tank, and the temperature of the solution was adjusted to 40°C. The aluminum alloy plate was immersed in this solution for one minute and was then washed with water. Next, the aluminum alloy plate was immersed for one minute in an aqueous solution containing hydrazine monohydrate at a concentration of 3.5% and having a temperature of 60°C and was then washed with water. The aluminum alloy plate was then dried by a hot air drier at 60°C for 20 minutes. The obtained aluminum alloy plate was wrapped in aluminum foil and then put in a polyethylene bag, and the bag was then sealed. Next day, the surface of the aluminum alloy plate was observed with an electron microscope "S-4800" (produced by Hitachi, Ltd., Tokyo, Japan) at a magnification of 100,000. As a result, it was confirmed that the entire surface of the aluminum alloy plate was covered with recesses having diameters in a range of 20 to 40 nm and the number average inner diameter of 25 nm.

### Treatment 2

Holes were formed on end portions of aluminum alloy plates, and copper wires coated with vinyl chloride were inserted into ten-odd holes. The copper wires were bent such that the aluminum alloy plates did not overlap one another. Thus, all the aluminum alloy pates were hanged at the same time. Water containing an aluminum alloy degreasing agent "NE-6" (produced by Meltex Inc.) at a concentration of 7.5% were put in a tank, and the temperature of the solution was adjusted to 75°C. Thus, the aluminum alloy degreasing agent was heated and melted. The aluminum alloy plates were immersed in this solution for five minutes and were then washed well with water.

Next, an aqueous solution containing caustic soda at a concentration of 10% and having a temperature of 50°C was prepared in a different tank. The aluminum alloy plate was immersed in this solution for 0.5 minute and was then washed well with water. Next, a liquid containing nitric acid at a concentration of 60% and having a temperature of 90°C was prepared in a different tank. The aluminum alloy plate was immersed in this liquid for 15 seconds and was then washed well with water. Next, an aqueous solution containing sulfuric acid at a concentration of 5% and having a temperature of 20°C was prepared in a different tank. An anode of a DC power supply "ASR3SD-150-500 (produced by Chuo Seisakusho, Ltd.)" was connected to a hole portion of the aluminum alloy plate, and a cathode of the DC power supply was connected to a lead plate placed in a tank. Then, anodic oxidation was performed by constant current control at a current density of 5 A/dm². The anodic oxidation was performed for 40 minutes, and the aluminum alloy plate was then washed with water. The aluminum alloy plate was put in a hot air drier and dried for an hour at 60°C. One day later, the surface of the aluminum alloy plate was observed with the electron microscope. It was confirmed that the surface of the aluminum plate was covered with fine holes (recesses) having the number average inner diameter of 17 nm.

### Treatment 3

The aluminum alloy plate was immersed in an etching solution A (aqueous solution) having the following composition for one minute for removal of a rust preventive film. Next, the aluminum alloy plate was immersed in an etching solution B (aqueous solution) having the following composition for five minutes for etching of the surface of the metal part. By this etching, the surface of the aluminum alloy plate was roughened. The surface of the aluminum alloy plate was observed with the electron microscope. It was confirmed that the surface of the aluminum alloy plate was covered with the recesses having the number average inner diameter of 8 µm.
Etching solution A (temperature of 20°C):
   Hydrogen peroxide of 26g/L
   Sulfuric acid of 90 g/L
Etching solution B (temperature of 25°C):
   Hydrogen peroxide of 80g/L
   Sulfuric acid of 90 g/L
   Benzotriazole of 5g/L
   Sodium chloride of 0.2 g/L

### Treatment 4

The aluminum alloy plate was subjected to the surface treatment by the technology "AMALPHA" produced by Mec Co., Ltd. According to this treatment method, first, the aluminum alloy plate was subjected to the degreasing treatment. Then, the aluminum alloy plate was immersed in a commercially available alkaline aqueous solution and acidic aqueous solution in order. Thus, the surface of the aluminum alloy plate was roughened. After this surface roughening treatment, metal oxides deposited on the surface of the aluminum alloy plate were removed. Thus, the surface treatment was performed. The surface of the aluminum alloy plate was observed with the electron microscope. It was confirmed that the surface of the aluminum alloy plate was covered with the recesses having the number average inner diameter of 3 µm.

### Treatment 5

The surface of the aluminum alloy plate was subjected to the surface treatment by continuous wave laser irradiation described in International Publication No. 2015/008771, Example 3.

### Evaluation Method

### Extrusion/kneading temperature

The thermally conductive resin composition is produced by extrusion, melting, and kneading, and a temperature during the production varies depending on the thermoplastic resin (A). The extrusion, melting, and kneading were performed at an extrusion barrel temperature shown in Table 1.

### Molding condition

A molding temperature varies depending on the thermoplastic resin (A) used. The molded body was produced by injection molding at the molding temperature shown in Table 1. Further, the molding was performed under conditions that an injection speed is fixed to 150 mm/s, and injection pressure is fixed to 150 MPa.

### Joining property evaluation

Each of the metal plates subjected to Treatments 1 to 5 was placed in a die, and the metal resin composite (direct gate, gate diameter of 3mm) shown in Fig. 3 was produced by using an injection molding device "Si-30IV" produced by Toyo Machinery & Metal Co., Ltd. The metal and the resin in the produced composite were separated from each other at the joint surface, and the joining property of each composite was evaluated based on the state of the destroyed surface as below.

Excellent: A tool is required for the separation, and the resin remains on the metal.

Good: After the composite is taken out, the metal and the resin can be separated from each other by hands, but resistance is felt, and the resin remains on the metal.

Bad: After the composite is taken out, the metal and the resin can be separated from each other by hands, and the resin does not remain on the metal. Or, the metal and the resin are separated from each other without being contacted by hands.

### Joining strength

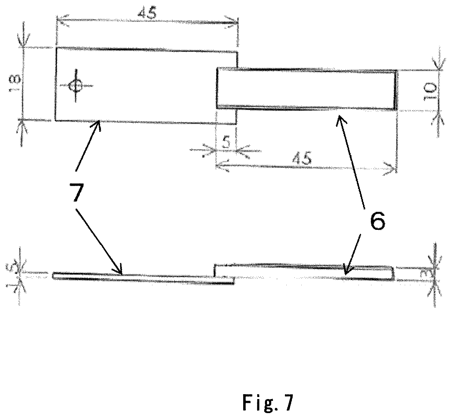

Each of the metal plates subjected to Treatments 1 to 5 was placed in a die, and the metal resin composite shown in Fig. 7 was produced by using an injection molding device "FN1000" produced by Nissei Plastic Industrial Co., Ltd. (The area of the joint surface between a resin portion 6 and a metal portion 7 was 50 mm².) Tensile strength at break at the joint surface, i.e., the joining strength at the joint surface was measured according to ISO19095 in such a manner that an end portion of the resin portion and an end portion of the metal portion in the produced metal resin composite were pulled in opposite directions.

### Volume average particle diameter of graphite

The volume average particle diameter of the graphite was measured by a Microtrac particle size distribution measuring device (MICROTRAC MT3300EXII produced by Nikkiso Co., Ltd.) in such a manner that: graphite particles were input to a water solvent; and the mixture was then subjected to ultrasonic vibration for 60 seconds. The volume average particle diameter of the graphite particles after the molding was measured in such a manner that: the metal plate was subjected to Treatment 2; only the resin portion of the metal resin composite obtained in the above joining property evaluation was taken out; the resin portion was baked at 620°C for an hour; only the graphite particles contained in the resin were taken out; and the volume average particle diameter of the graphite particles were measured.

### Aspect ratio of graphite

The aspect ratio of the graphite was calculated using an average value of longest diameters of 100 graphite particles and an average value of shortest diameters of the 100 graphite particles by a scanning electron microscope (SEM) (JSM-6060LA produced by JEOL Ltd.). The aspect ratio of the graphite particle after the molding was calculated by the same method as above using the metal resin composite obtained in the above joining property evaluation after subjecting the metal plate to Treatment 2.

### Number average molecular weight

A part of the resin portion of the metal resin composite obtained in the above joining property evaluation after subjecting the metal plate to Treatment 2 was dissolved at a concentration of 0.25 wt.% in a mixed solvent in which a volume ratio between p-chlorophenol (produced by Tokyo Chemical Industry Co., Ltd.) and toluene was 3 : 8. Then, only the thermoplastic resin was extracted. Thus, a sample was prepared. Using polystyrene as a standard substance, a sample solution was prepared in the same manner as above. The number average molecular weight was measured by a high-temperature GPC (350 HT-GPC System produced by Viscotek) under conditions that a column temperature was 80°C, and a flow velocity was 1.00 mL/min. A refractive index detector (RI) was used as a detector.

### Thermal conductivity

A molded body having a diameter of 26 mm and a thickness of 1 mm was produced by an injection molding machine (Si-15IV produced by Toyo Machinery & Metal Co., Ltd.) using pellets of the obtained thermally conductive resin composition. Then, the thermal conductivity in the surface direction (In-Plane thermal conductivity) and the thermal conductivity in the thickness direction (Thru-Plane thermal conductivity) in the atmosphere at room temperature were measured according to ASTM E1461 by a laser flash method thermal conductivity measuring device (LFA447 produced by NETZSCH).

### Specific gravity

The specific gravity of the molded body having the diameter of 26 mm and the thickness of 1 mm was measured by an underwater substitution method according to ISO1183.

### Moldability

A molded body was produced using pellets of the obtained thermally conductive resin composition by an injection molding machine (Si-30IV produced by Toyo Machinery & Metal Co., Ltd.) in such a manner that resin was supplied to a spiral tube having a width of 10 mm and a thickness of 1 mm (pitch of 5 mm) from a center of the spiral tube at a molding temperature and die temperature shown in Table 1 and determined in accordance with the thermoplastic resin at injection pressure of 150 MPa and an injection speed of 150 mm/s. Then, a flow length of melted resin of the molded body was measured. The moldability was determined as follows: "Excellent" denotes that the flow length was 120 mm or more; "Good" denotes that the flow length was 80 to 120 mm; and "Bad" denotes that the flow length was less than 80 mm.

### Flammability

The flammability was measured according to requirements of UL94. A test piece was vertically fixed by clamping an upper end of the test piece. A lower end of the test piece was exposed to predetermined flame for 10 seconds, and the flame was removed. Then, a burning time of the test piece was measured for the first time. When the fire on the test piece went out, the lower end of the test piece was immediately exposed to the flame again, and the flame was removed. Thus, the burning time of the test piece was measured for the second time. The same measurements were repeatedly performed for five test pieces. Thus, ten data pieces that were five data pieces of the first burning time and five data pieces of the second burning time were obtained. The total of the ten data pieces is referred to as a "time T," and a maximum value among the ten data pieces is referred to as a "time M." The flammability corresponds to "V-0" when: the time T is 50 seconds or less; the time M is 10 seconds or less; the fire does not reach the clamp; and a case where a melted material with flame drops to cotton located under the test piece by 12 inches to ignite the cotton does not occur. The flammability corresponds to "V-1" when: the time T is 250 seconds or less; the time M is 30 seconds or less; and the other conditions are the same as the conditions of "V-0." The flammability of the thermally conductive resin composition not containing the flame retardant is shown by HB.

### Heat radiation property of metal resin composite

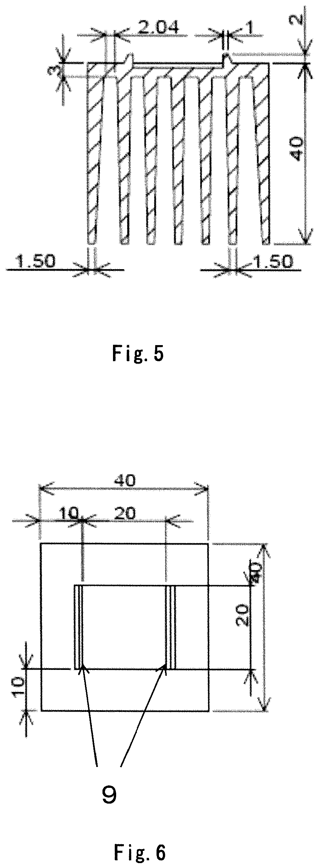

An aluminum alloy plate (20 mm × 20 mm, thickness of 1 mm) was placed in a die, and a heat sink shown in Figs. 4 to 6 was produced by an injection molding device (Si-100IV produced by Toyo Machinery & Metal Co., Ltd.) using pellets of the obtained thermally conductive resin composition. The aluminum alloy plate was provided at a recess of a heat sink upper surface portion 8 shown in Fig. 4. A heat generating body having a size of 5 mm × 5 mm and a thickness of 2 mm was placed at a center of the aluminum alloy plate. The heat sink was fixed with the fin facing downward, and 10 W was applied to the heat generating body in a 20°C atmosphere. After the heat generating body was left for two hours, the temperature thereof was measured.

**Table 1**

| Thermoplastic resin (A) | Extrusion, melting, and kneading | Molding | |
|---|---|---|---|
| | Barrel temperature (°C) | Cylinder temperature (°C) | Mold temperature (°C) |
| A-1 or A-2 | 280 | 280 | 120 |
| A-3 | 260 | 280 | 120 |
| A-4 | 260 | 260 | 110 |
| A-1 and A-4 | 280 | 280 | 120 |
| A-5 | 260 | 270 | 120 |
| A-6 | 310 | 330 | 140 |

### Examples 1 to 11

The thermoplastic resins were dried by a hot air drier (at a drying temperature of 140°C for (A-1) to (A-4) and (A-6) and 120°C for (A-5)) for four hours. Then, mixtures of the components shown in Table 2 were prepared based on weight ratios shown in Table 2. Then, 0.3 parts by weight of a phenol-based stabilizer (AO-60 produced by ADEKA CORPORATION) and 0.3 parts by weight of a phosphorus-based antioxidant (ADK STAB PEP-36 produced by ADEKA CORPORATION) were added to 100 parts by weight of each of the resin compositions. Each of the resulting mixtures was melted and kneaded by a 25 mm same direction rotation completely-meshing type twin screw extruder MFU25TW-60HG-NH-1300 produced by Technovel Corporation at a discharge rate of 20 kg/h, a screw revolution speed of 150 rpm, and an extrusion barrel temperature shown in Table 1. Thus, resin composition pellets were obtained. The molded bodies were produced by injection molding using the obtained resin composition pellets, and various evaluations were performed. Results of the various evaluations were shown in Table 2.

### Examples 12 to 13

The heat sink shown in Figs. 4 to 6 was produced using the pellets of the resin composition obtained in Example 4. The aluminum alloy plate subjected to Treatment 1 or 4 was used. The evaluations of the joining property and heat radiation property of the obtained composite were performed. Results of the evaluations are shown in Table 3.

### Comparative Examples 1 to 3

Comparative Examples 1 to 3 were performed in the same manner as Examples 2, 8, and 9 except that: the aluminum alloy plate used was not subjected to the surface treatment; and the compounding ratio was changed. The recesses were not formed on the surface of the metal, and the number average inner diameter of the recesses was 0 µm. Results of the various evaluations were shown in Table 4.

### Comparative Example 4

Comparative Example 4 was performed in the same manner as Example 12 except that the aluminum alloy plate used was not subjected to the surface treatment. The recesses were not formed on the surface of the metal, and the number average inner diameter of the recesses was 0 µm. The evaluations of the joining property and heat radiation property of the obtained composite were performed. Results of the evaluations are shown in Table 3.

### Comparative Example 5

Comparative Example 5 was performed in the same manner as Comparative Example 4 except that the metal plate was fixed by subjecting a rib portion 9 of the composite obtained in Comparative Example 4 to ultrasound welding. The evaluations of the joining property and heat radiation property of the obtained composite were performed. Results of the evaluations are shown in Table 3.

**Table 2**

| | | | Examples | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| Thermoplastic resin (A) | A-1 | Mass% | 65 | 60 | 60 | 30 | 20 | 45 | | | | | |
| | A-2 | | | | | | | | 60 | | | | |
| | A-3 | | | | | | | | | 60 | | | |
| | A-4 | | | | | 15 | 15 | | | | 60 | | |
| | A-5 | | | | | | | | | | | 55 | |
| | A-6 | | | | | | | | | | | | 60 |
| Inorganic particles (B1) | B1-1 | | 30 | 40 | | 50 | 60 | 35 | 40 | 40 | 40 | 45 | 40 |
| | B1-2 | | | | 40 | | | | | | | | |
| Inorganic fibers (B2) | B2 | | 5 | | | 5 | 5 | 7 | | | | | |
| Flame retardant | D | | | | | | | 10 | | | | | |
| Flame retardant promoter | E | | | | | | | 3 | | | | | |
| Joining property | Surface treatment | Treatment 1 | Excellent | Excellent | Excellent | Excellent | Excellent | Excellent | Excellent | Excellent | Excellent | Excellent | Excellent |
| | | Treatment 2 | Excellent | Excellent | Good | Excellent | Excellent | Good | Excellent | Excellent | Excellent | Excellent | Excellent |
| | | Treatment 3 | Excellent | Excellent | Good | Good | Good | Good | Good | Excellent | Good | Good | Good |
| | | Treatment 4 | Excellent | Excellent | Good | Excellent | Excellent | Excellent | Excellent | Excellent | Excellent | Excellent | Excellent |
| | | Treatment 5 | Excellent | Excellent | Excellent | Excellent | Excellent | Excellent | Excellent | Excellent | Excellent | Excellent | Excellent |
| Joining strength (MPa) | Surface treatment | Treatment 1 | 14 | 12 | 10 | 9 | 8 | 9 | 10 | 10 | 10 | 8 | 8 |
| | | Treatment 2 | 8 | 8 | 4 | 8 | 7 | 5 | 7 | 7 | 8 | 6 | 6 |
| | | Treatment 3 | 5 | 5 | 2 | 2 | 2 | 1 | 2 | 5 | 3 | 1 | 1 |
| | | Treatment 4 | 7 | 7 | 4 | 5 | 7 | 5 | 7 | 7 | 6 | 5 | 5 |
| | | Treatment 5 | 13 | 12 | 11 | 9 | 8 | 9 | 10 | 11 | 10 | 7 | 7 |
| Specific gravity | | | 1.5 | 1.6 | 1.6 | 1.7 | 1.7 | 1.8 | 1.6 | 1.6 | 1.6 | 1.5 | 1.6 |
| Number average molecular weight | | | 22,300 | 21,800 | 21,500 | 20,500 | 20,800 | 20,500 | 36,800 | 17,700 | 18,800 | - | - |
| Volume average particle diameter of graphite particle contained in metal resin composite | µm | | 78 | 80 | 36 | 78 | 74 | 68 | 78 | 78 | 82 | 76 | 73 |
| Aspect ratio of graphite particle contained in metal resin composite | | | 350 | 400 | 250 | 300 | 300 | 300 | 350 | 300 | 350 | 350 | 400 |
| Fixed carbon content | Mass% | | 99.9 | 99.9 | 99.9 | 99.9 | 99.9 | 99.9 | 99.9 | 99.9 | 99.9 | 99.9 | 99.9 |
| Thermal conductivity in surface direction | W/(m·K) | | 6.5 | 12.1 | 10.6 | 22.1 | 31.0 | 11.5 | 12.3 | 12.4 | 11.5 | 11.8 | 11.5 |
| Thermal conductivity in thickness direction | | | 0.9 | 1.2 | 1.0 | 2.3 | 3.4 | 1.1 | 1.1 | 1.2 | 1.1 | 1.1 | 1.2 |
| Moldability | | | Excellent | Excellent | Good | Good | Good | Excellent | Good | Excellent | Excellent | Excellent | Excellent |
| Flammability | | | HB | HB | HB | HB | HB | V-0 | HB | HB | HB | HB | HB |

**Table 3**

| | | | Example | Example | Comparative Examples | |
|---|---|---|---|---|---|---|
| | | | 12 | 13 | 4 | 5 |
| Joining property | Surface treatment | No treatment | - | - | Bad | Bad |
| | | Treatment 1 | Excellent | - | - | - |
| | | Treatment 4 | - | Excellent | - | - |
| Heat radiation property of metal resin composite | | °C | 86.8 | 87.8 | 95.2 | 94.1 |

**Table 4**

| | | | Comparative Examples | | |
|---|---|---|---|---|---|
| | | | 1 | 2 | 3 |
| Thermoplastic resin (A) | A-1 | Mass% | 60 | | |
| | A-2 | | | | |
| | A-3 | | | 60 | |
| | A-4 | | | | 60 |
| | A-5 | | | | |
| | A-6 | | | | |
| Inorganic particles (B1) | B1-1 | | 40 | 40 | 40 |
| | B1-2 | | | | |
| Inorganic fibers (B2) | B2 | | | | |
| Flame retardant | D | | | | |
| Flame retardant promoter | E | | | | |
| Joining property | Surface treatment | No treatment | Bad | Bad | Bad |
| Joining strength (MPa) | Surface treatment | No treatment | 0 | 0 | 0 |
| Specific gravity | | | 1.6 | 1.6 | 1.6 |
| Number average molecular weight | | | 21,600 | 18,100 | 18,800 |
| Volume average particle diameter of graphite particle contained in metal resin composite | | µm | 78 | 76 | 81 |
| Aspect ratio of graphite particle contained in metal resin composite | | | 400 | 300 | 350 |
| Fixed carbon content | | Mass% | 99.9 | 99.9 | 99.9 |
| Thermal conductivity in surface direction | | W/(m·K) | 12.1 | 12.4 | 11.5 |
| Thermal conductivity in thickness direction | | | 1.2 | 1.2 | 1.1 |
| Moldability | | | Excellent | Excellent | Excellent |
| Flammability | | | HB | HB | HB |

The results of Example 2 and Comparative Example 1 show that the excellent joining property is obtained by using the metal plate subjected to the surface treatment of the present invention.

The results of Examples 2 and 3 show that as the volume average particle diameter of the graphite particles before the melting and kneading increases, the volume average particle diameter of the graphite particles contained in the metal resin composite increases, and the joining property improves more. In addition, as the volume average particle diameter of the graphite particles increases, the moldability improves. Due to these two reasons, it can be said that the graphite particles having large particle diameters hardly flow into the fine recesses formed by the surface treatment, and only the resin easily flows into the recesses.

Due to the results of Examples 2 and 7 to 11, it can be said that according to the present invention, the excellent joining property can be obtained regardless of the type of the thermoplastic resin and the amount of filler.

Regarding the heat radiation property, according to the results of Example 12 or 13 and Comparative Example 4, it can be said that the metal and the resin can be tightly joined to each other at the interface by using the metal plate subjected to the metal surface treatment, and the heat of the heat generating body can be diffused by the metal to be efficiently transferred to the resin portion. Further, even though the metal plate was fixed in Comparative Example 5, the result of Comparative Example 5 was substantially the same as the result of Comparative Example 4. Therefore, it can be said that it is important to tightly join the metal member and the resin member to each other at the interface.

The metal resin composite of the present invention can be integrally molded by injection molding, and the number of steps of the present invention can be made smaller than that of conventional methods. Further, the present invention does not require a material that reduces resistance at the interface between the metal and the resin, and the metal resin composite of the present invention can be easily produced at low cost. Furthermore, since the metal resin composite of the present invention has excellent thermal conductivity, excellent moldability, and low specific gravity, the metal resin composite of the present invention can be used as a substitute for, for example, a metal having high thermal conductivity. The metal resin composite of the present invention is light in weight and is high in the degree of freedom of shape. Thus, the metal resin composite of the present invention is applicable to various applications, such as electronic/electrical apparatus parts and automobiles.

### Reference Signs List

- 1: LED module
- 2: circuit substrate
- 3: heat sink board
- 4: heat sink fin
- 5: gate
- 6: resin portion
- 7: metal portion
- 8: upper surface portion of heat sink
- 9: rib

## Claims

1. A metal resin composite comprising:
a member made of thermally conductive resin composition; and
a member made of metal and including a surface on which fine recesses having a number average inner diameter of 1 to 200 nm are formed by a surface treatment, these members contacting with each other and being joined to each other in such a manner that the thermally conductive resin composition flows into and is fixed to the recesses by injection molding of the thermally conductive resin composition, wherein:
the thermally conductive resin composition contains a thermoplastic resin (A) and an inorganic filler (B);
the thermoplastic resin (A) contains a crystalline polyester based resin containing one or more of polybutylene terephthalate, polyethylene terephthalate, and polyester-polyether copolymer;
thermal conductivity of the thermally conductive resin composition in a surface direction is 1 W/(m·K) or more; and
the inorganic filler (B) is at least one selected from the group consisting of inorganic particles (B1) having a thermal conductivity of 2 W/(m·K) or more and a volume average particle diameter of 40 to 700 µm, wherein the inorganic particles (B1) comprise flaked graphite; and
wherein the content of the inorganic filler (B) is 30 to 60 wt.%, based on the entire thermally conductive resin composition as 100 wt.%.

2. The metal resin composite according to claim 1, wherein the inorganic filler (B) further comprises inorganic fibers (B2) having a thermal conductivity of 1 W/(m·K) or more, a number average fiber diameter of 1 to 50 µm, and a number average fiber length of 6 mm or less.

3. The metal resin composite according to claim 1 or 2, wherein the surface treatment includes a treatment of immersing the member made of the metal in an acidic aqueous solution and/or a basic aqueous solution.

4. The metal resin composite according to claim 1 or 2, wherein the surface treatment includes:
a first treatment of immersing the member made of the metal in an acidic aqueous solution and/or a basic aqueous solution; and
a second treatment of, after the first treatment, immersing the member made of the metal in an aqueous solution containing at least one selected from the group consisting of ammonia, hydrazine, and water-soluble amine compounds.

5. The metal resin composite according to claim 1 or 2, wherein the surface treatment includes a treatment of irradiating the surface of the member made of the metal with a laser.

6. The metal resin composite according to any one of claims 1 to 5, wherein the specific gravity of the thermally conductive resin composition is 1.2 to 2.1.

7. The metal resin composite according to any one of claims 1 to 6, wherein:
a fixed carbon content of the inorganic particles (B1) contained in the metal resin composite is 98 mass% or more; and
the inorganic particles (B1) which are flaked graphite have an aspect ratio of 21 or more.

8. The metal resin composite according to any one of claims 1 to 7, wherein the metal is a metal selected from the group consisting of aluminum, copper, magnesium, and alloys of these metals.

9. The metal resin composite according to any one of claims 1 to 8, wherein the metal resin composite is a heat sink that cools an LED module.

10. The metal resin composite according to claim 9, wherein the heat sink is a car LED lamp heat sink.

11. A method of producing the metal resin composite according to any one of claims 1 to 10,
the method comprising causing the member made of the thermally conductive resin composition and the member made of the metal, including the surface on which the fine recesses having a number average inner diameter of 1 to 200 nm are formed by the surface treatment, to contact with each other and be joined to each other in such a manner that by the injection molding of the thermally conductive resin composition under existence of the member made of the metal, the thermally conductive resin composition flows into and is fixed to the recesses, wherein: the thermally conductive resin composition contains a thermoplastic resin (A) and an inorganic filler (B);the thermoplastic resin (A) contains a crystalline polyester based resin containing one or more of polybutylene terephthalate, polyethylene terephthalate, and polyester-polyether copolymer; thermal conductivity of the thermally conductive resin composition in a surface direction is 1 W/(m.K) or more; and the inorganic filler (B) is at least one selected from the group consisting of inorganic particles (B1) having a thermal conductivity of 2 W/(m.K) or more and a volume average particle diameter of 40 to 700 µm, wherein the inorganic particles (B1) comprise flaked graphite; and wherein the content of the inorganic filler (B) is 30 to 60 wt.%, based on the entire thermally conductive resin composition as 100 wt.%.

12. The method according to claim 11, further comprising producing the thermally conductive resin composition by melting and kneading.

## Patentansprüche

1. Ein Metallharzkomposit, umfassend:
ein Element, das hergestellt ist aus wärmeleitfähiger Harzzusammensetzung; und
ein Element, das hergestellt ist aus Metall und welches eine Oberfläche aufweist, auf der feine Aussparungen mit einem Zahlenmittel des inneren Durchmessers von 1 bis 200 nm durch Oberflächenbehandlung gebildet sind, wobei diese Elemente miteinander in Kontakt stehen und miteinander verbunden sind, derart, dass die wärmeleitfähige Harzzusammensetzung durch Injektionsformen der wärmeleitfähigen Harzzusammensetzung in die Aussparungen hineinfließt und an diese fixiert wird,
wobei:
die wärmeleitfähige Harzzusammensetzung ein thermoplastisches Harz (A) und einen anorganischen Füllstoff (B) enthält;
das thermoplastische Harz (A) ein kristallines auf Polyester basierendes Harz enthält, das eines oder mehrere aus Polybutylenterephthalat, Polyethylenterephthalat und Polyester-Polyether-Copolymer enthält;
die Wärmeleitfähigkeit der wärmeleitfähigen Harzzusammensetzung in einer Oberflächenrichtung 1 W/(m·K) oder mehr beträgt; und
der anorganische Füllstoff (B) mindestens einer ist, ausgewählt aus der Gruppe bestehend aus anorganischen Teilchen (B1) mit einer Wärmeleitfähigkeit von 2 W/(m·K) oder mehr und einem Volumenmittel des Teilchendurchmessers von 40 bis 700 µm, wobei die anorganischen Teilchen (B1) Flockengraphit umfassen; und
wobei der Gehalt an anorganischen Füllstoff (B) 30 bis 60 Gew.-% beträgt, bezogen auf die gesamte wärmeleitfähige Harzzusammensetzung als 100 Gew.-%.

2. Das Metallharzkomposit nach Anspruch 1, wobei der anorganische Füllstoff (B) ferner anorganische Fasern (B2) mit einer Wärmeleitfähigkeit von 1 W/(m·K) oder mehr, einem Zahlenmittel des Faserdurchmessers von 1 bis 50 µm und einem Zahlenmittel der Faserlänge von 6 mm oder weniger, umfasst.

3. Das Metallharzkomposit nach Anspruch 1 oder 2, wobei die Oberflächenbehandlung eine Behandlung beinhaltet, bei der das Element, das hergestellt ist aus Metall, in eine saure wässrige Lösung und/oder eine basische wässrige Lösung getaucht wird.

4. Das Metallharzkomposit nach Anspruch 1 oder 2, wobei die Oberflächenbehandlung beinhaltet:
eine erste Behandlung, bei der das Element, das hergestellt ist aus Metall, in eine saure wässrige Lösung und/oder eine basische wässrige Lösung getaucht wird; und
eine zweite Behandlung, bei der, nach der ersten Behandlung, das Element, das hergestellt ist aus Metall, in eine wässrige Lösung, die mindestens eines, ausgewählt aus der Gruppe bestehend aus Ammoniak, Hydrazin und wasserlöslichen Aminverbindungen, enthält, getaucht wird.

5. Das Metallharzkomposit nach Anspruch 1 oder 2, wobei die Oberflächenbehandlung eine Behandlung beinhaltet, bei der die Oberfläche des Elements, das hergestellt ist aus Metall, mit einem Laser bestrahlt wird.

6. Das Metallharzkomposit nach einem der Ansprüche 1 bis 5, wobei die spezifische Dichte der wärmeleitfähigen Harzzusammensetzung 1,2 bis 2,1 beträgt.

7. Das Metallharzkomposit nach einem der Ansprüche 1 bis 6, wobei:
ein Gehalt an gebundenen Kohlenstoff der anorganischen Teilchen (B1), die in dem Metallharzkomposit enthalten sind, 98 Massen-% oder mehr beträgt; und
die anorganischen Teilchen (B1), die Flockengraphit sind, ein Seitenverhältnis von 21 oder mehr aufweisen.

8. Das Metallharzkomposit nach einem der Ansprüche 1 bis 7, wobei das Metall ein Metall ist, ausgewählt aus der Gruppe bestehend aus Aluminium, Kupfer, Magnesium und Legierungen dieser Metalle.

9. Das Metallharzkomposit nach einem der Ansprüche 1 bis 8, wobei das Metallharzkomposit ein Kühlkörper ist, der ein LED-Modul kühlt.

10. Das Metallharzkomposit nach Anspruch 9, wobei der Kühlkörper ein Kühlkörper für eine LED-Autolampe ist.

11. Ein Verfahren zur Herstellung des Metallharzkomposits nach einem der Ansprüche 1 bis 10,
wobei das Verfahren Bewirken, dass das Element, das hergestellt ist aus der wärmeleitfähigen Harzzusammensetzung, und das Element, das hergestellt ist aus dem Metall, welches die Oberfläche, auf der die feinen Aussparungen mit einem Zahlenmittel des inneren Durchmessers von 1 bis 200 nm durch die Oberflächenbehandlung gebildet sind, beinhaltet, miteinander in Kontakt kommen und sich miteinander verbinden, derart, dass durch das Injektionsformen der wärmeleitfähigen Harzzusammensetzung in Gegenwart des Elements, das hergestellt ist aus dem Metall, die wärmeleitfähige Harzzusammensetzung in die Aussparungen hineinfließt und an diese fixiert wird, umfasst, wobei: die wärmeleitfähige Harzzusammensetzung ein thermoplastisches Harz (A) und einen anorganischen Füllstoff (B) enthält; das thermoplastische Harz (A) ein kristallines auf Polyester basierendes Harz enthält, das eines oder mehrere aus Polybutylenterephthalat, Polyethylenterephthalat und Polyester-Polyether-Copolymer enthält; die Wärmeleitfähigkeit der wärmeleitfähigen Harzzusammensetzung in einer Oberflächenrichtung 1 W/(m·K) oder mehr beträgt; und der anorganische Füllstoff (B) mindestens einer ist, ausgewählt aus der Gruppe bestehend aus anorganischen Teilchen (B1) mit einer Wärmeleitfähigkeit von 2 W/(m-K) oder mehr und einem Volumenmittel des Teilchendurchmessers von 40 bis 700 µm, wobei die anorganischen Teilchen (B1) Flockengraphit umfassen; und wobei der Gehalt an anorganischem Füllstoff (B) 30 bis 60 Gew.-% beträgt, bezogen auf die gesamte wärmeleitfähige Harzzusammensetzung als 100 Gew.-%.

12. Das Verfahren nach Anspruch 11, ferner umfassend Herstellen der wärmeleitfähigen Harzzusammensetzung durch Schmelzen und Kneten.

## Revendications

1. Composite de métal et de résine comprenant :
un élément fait d'une composition de résine thermiquement conductrice ; et
un élément fait d'un métal et comprenant une surface sur laquelle de fins évidements ayant un diamètre intérieur moyen en nombre de 1 à 200 nm sont formés par un traitement de surface,
ces éléments venant en contact mutuel et étant joints l'un à l'autre de telle manière que la composition de résine thermiquement conductrice s'écoule dans les évidements et y soit fixée par moulage par injection de la composition de résine thermiquement conductrice, dans lequel :
la composition de résine thermiquement conductrice contient une résine thermoplastique (A) et une charge inorganique (B) ;
la résine thermoplastique (A) contient une résine à base de polyester cristallin contenant un ou plusieurs parmi le poly(téréphtalate de butylène), le poly(téréphtalate d'éthylène), et un copolymère de polyester-polyéther ;
la conductivité thermique de la composition de résine thermiquement conductrice dans la direction de la surface est de 1 W/(m•K) ou plus ; et
la charge inorganique (B) est au moins l'une choisie dans le groupe constitué par les particules inorganiques (B1) ayant une conductivité thermique de 2 W/(m•K) ou plus et un diamètre moyen de particule en volume de 40 à 700 µm, dans laquelle les particules inorganiques (B1) comprennent du graphite en paillettes ; et
dans lequel la teneur en la charge inorganique (B) est de 30 à 60 % en poids par rapport à la totalité de la composition de résine thermiquement conductrice de 100 % en poids.

2. Composite de métal et de résine selon la revendication 1, dans lequel la charge inorganique (B) comprend en outre des fibres inorganiques (B2) ayant une conductivité thermique de 1 W/(m•K) ou plus, un diamètre de fibre moyen en nombre de 1 à 50 µm, et une longueur de fibre moyenne en nombre de 6 mm ou moins.

3. Composite de métal et de résine selon la revendication 1 ou 2, dans lequel le traitement de surface comprend un traitement d'immersion de l'élément fait de métal dans une solution aqueuse acide et/ou une solution aqueuse basique.

4. Composite de métal et de résine selon la revendication 1 ou 2, dans lequel le traitement de surface comprend :
un premier traitement d'immersion de l'élément fait de métal dans une solution aqueuse acide et/ou une solution aqueuse basique ; et
un deuxième traitement, après le premier traitement, d'immersion de l'élément fait de métal dans une solution aqueuse contenant au moins l'un choisi dans le groupe constitué par l'ammoniac, l'hydrazine, et les composés amine solubles dans l'eau.

5. Composite de métal et de résine selon la revendication 1 ou 2, dans lequel le traitement de surface comprend un traitement d'irradiation de la surface de l'élément fait de métal avec un laser.

6. Composite de métal et de résine selon l'une quelconque des revendications 1 à 5, dans lequel la densité de la composition de résine thermiquement conductrice est de 1,2 à 2,1.

7. Composite de métal et de résine selon l'une quelconque des revendications 1 à 6, dans lequel :
la teneur en carbone fixé des particules inorganiques (B1) contenues dans le composite de métal et de résine est de 98 % en masse ou plus ; et
les particules inorganiques (B1) qui sont du graphite en paillettes ont un rapport d'aspect de 21 ou plus.

8. Composite de métal et de résine selon l'une quelconque des revendications 1 à 7, dans lequel le métal est un métal choisi dans le groupe constitué par l'aluminium, le cuivre, le magnésium, et les alliages de ces métaux.

9. Composite de métal et de résine selon l'une quelconque des revendications 1 à 8, lequel composite de métal et de résine est un dissipateur thermique qui refroidit un module de DEL.

10. Composite de métal et de résine selon la revendication 9, dans lequel le dissipateur thermique est un dissipateur thermique pour lampe à DEL d'automobile.

11. Méthode de production du composite de métal et de résine de l'une quelconque des revendications 1 à 10,
la méthode comprenant la mise en contact mutuel de l'élément fait de la composition de résine thermiquement conductrice et de l'élément fait de métal, y compris la surface sur laquelle les fins évidements ayant un diamètre intérieur moyen en volume de 1 à 200 nm sont formés par le traitement de surface, et leur jonction l'un à l'autre de telle manière que, par le moulage par injection de la composition de résine thermiquement conductrice en présence de l'élément fait de métal, la composition de résine thermiquement conductrice s'écoule dans les évidements et y soit fixée, dans laquelle : la composition de résine thermiquement conductrice contient une résine thermoplastique (A) et une charge inorganique (B) ; la résine thermoplastique (A) contient une résine à base de polyester cristallin contenant un ou plusieurs parmi le poly(téréphtalate de butylène), le poly(téréphtalate d'éthylène), et un copolymère de polyester-polyéther ; la conductivité thermique de la composition de résine thermiquement conductrice dans la direction de la surface est de 1 W/(m•K) ou plus ; et la charge inorganique (B) est au moins l'une choisie dans le groupe constitué par les particules inorganiques (B1) ayant une conductivité thermique de 2 W/(m•K)ou plus et un diamètre moyen de particule en volume de 40 à 700 µm, dans laquelle les particules inorganiques (B1) comprennent du graphite en paillettes ; et dans laquelle la teneur en la charge inorganique (B) est de 30 à 60 % en poids par rapport à la totalité de la composition de résine thermiquement conductrice de 100 % en poids.

12. Méthode selon la revendication 11, comprenant en outre la production de la composition de résine thermiquement conductrice par fusion et malaxage.
